# EUROPEAN PATENT APPLICATION

(11) **EP 4 791 147 A1**
(43) Date of publication of application: **12.08.2026**
(21) Application number: 25216498.3
(22) Date of filing: 18.11.2025
(51) Int. Cl.: H10D 30/67, H10D 86/60

(54) **TRANSISTOR SUBSTRATE, ELECTRONIC DEVICE INCLUDING THE SAME, AND METHOD OF MANUFACTURING THE TRANSISTOR SUBSTRATE**

(30) Priority: 07.02.2025 KR 20250015815
(71) Applicant: Samsung Display Co., Ltd., Yongin-si, Gyeonggi-do 17113 (KR)
(72) Inventor: Choi, Hyelim, Yongin-si, Gyeonggi-do 17113 (KR); Park, Joon Seok, Yongin-si, Gyeonggi-do 17113 (KR); Koo, Soyoung, Yongin-si, Gyeonggi-do 17113 (KR); Kim, Hyoung Do, Yongin-si, Gyeonggi-do 17113 (KR)
(74) Representative: Gulde & Partner

(57) **Abstract**

A transistor substrate includes a substrate and a first active pattern disposed on the substrate. The first active pattern includes a lower layer including an amorphous oxide semiconductor and having a first conductive region, a second conductive region, and a first channel region positioned the first and second conductive regions, and an upper layer disposed on the lower layer and including a crystalline oxide semiconductor. The transistor substrate further includes a first gate electrode disposed on the first active pattern and overlapping the first channel region in a plan view, a first connecting electrode contacting the first conductive region, and a second connecting electrode contacting the second conductive region. The first gate electrode and the first active pattern form a first transistor.

## Description

### TECHNICAL FIELD

Embodiments of the present disclosure relate to a display device. More particularly, embodiments of the present disclosure relate to a transistor substrate, an electronic device including the same, and a method of manufacturing the transistor substrate.

### DISCUSSION OF RELATED ART

With the advancement of information technology, display devices, which serve as communication interfaces between users and digital information, have become increasingly important. As a result, the adoption of various types of display devices, such as liquid crystal displays (LCDs), organic light-emitting diode (OLED) displays, and plasma display panels, continues to grow.

A display device typically includes a plurality of pixels, and each pixel may include at least one thin-film transistor (TFT), at least one capacitor, and at least one light-emitting element. For example, the active pattern of a TFT may be formed using amorphous silicon or polycrystalline silicon. More recently, thin-film transistors employing metal oxide semiconductors have been actively researched due to, for example, their higher charge carrier mobility compared to amorphous silicon, lower manufacturing cost than polycrystalline silicon, and better uniformity across a substrate.

### SUMMARY

Embodiments provide a transistor substrate capable of improving the characteristics of a driving transistor.

Embodiments provide an electronic device including the transistor substrate.

Embodiments provide a method of manufacturing the transistor substrate.

A transistor substrate according to embodiments of the present disclosure includes a substrate, a first active pattern disposed on the substrate and including a lower layer including an amorphous oxide semiconductor and having a first conductive region, a second conductive region, and a first channel region positioned between the first and second conductive regions, and an upper layer disposed on the lower layer and including a crystalline oxide semiconductor. The transistor substrate further includes a first gate electrode disposed on the first active pattern and overlapping the first channel region in a plan view, and constituting a first transistor together with the first active pattern, a first connecting electrode contacting the first conductive region, and a second connecting electrode contacting the second conductive region.

In an embodiment, a first-first hole surrounded by the first conductive region and a second-first hole surrounded by the second conductive region may be defined in the lower layer, and a first-second hole exposing the first-first hole and a second-second hole exposing the second-first hole may be defined in the upper layer. A width of the first-first hole may be smaller than a width of the first-second hole, and a width of the second-first hole may be smaller than a width of the second-second hole.

In an embodiment, the first connecting electrode may contact the first conductive region through the first-second hole and may not overlap the first-first hole in the plan view. The second connecting electrode may contact the second conductive region through the second-second hole and may not overlap the second-first hole in the plan view.

In an embodiment, the first connecting electrode may face the second connecting electrode in one direction, and a length of the lower layer in the one direction may be as about equal to a length of the upper layer in the one direction.

In an embodiment, the upper layer may have a third conductive region at least partially overlapping the first conductive region in the plan view, a fourth conductive region at least partially overlapping the second conductive region in the plan view, and a second channel region overlapping the first channel region in the plan view.

In an embodiment, the transistor substrate may further include a gate insulating layer disposed between the first active pattern and the first gate electrode. A first opening exposing the third conductive region, the first-first hole, and the first-second hole, and a second opening exposing the fourth conductive region, the second-first hole, and the second-second hole may be defined in the gate insulating layer.

In an embodiment, a thickness of the upper layer may be in a range of less than about 100 angstroms (Å) and a thickness of the lower layer may be in a range of more than about 50 angstroms (Å) and less than about 300 angstroms (Å).

In an embodiment, the transistor substrate may further include a second active pattern disposed on the substrate, including an amorphous oxide semiconductor, and having a conductive region and a channel region and a second gate electrode disposed on the second active pattern, overlapping the channel region in the plan view, and constituting a second transistor together with the second active pattern.

In an embodiment, the upper layer may have a third conductive region at least partially overlapping the first conductive region in the plan view, a fourth conductive region at least partially overlapping the second conductive region in the plan view, and a second channel region overlapping the first channel region in the plan view.

In an embodiment, a first hole surrounded by the first conductive region and a second hole surrounded by the second conductive region may be defined in the lower layer, and a third hole surrounded by the conductive region may be defined in the second active pattern.

In an embodiment, a first step may exist between an end portion of the upper layer facing the first connecting electrode and an end portion of the first conducting region exposed by the first hole and facing the first connecting electrode. A second step may exist between an end portion of the upper layer facing the second connecting electrode and an end portion of the second conducting region exposed by the second hole and facing the second connecting electrode.

An electronic device according to embodiments of the present disclosure includes a display device, a power supply which supplies power to the display device, and a processor which controls the display device. The display device includes a substrate, a first active pattern disposed on the substrate and including a lower layer including an amorphous oxide semiconductor and having a first conductive region, a second conductive region, and a first channel region positioned the first and second conductive regions, and an upper layer disposed on the lower layer and including a crystalline oxide semiconductor, a first gate electrode disposed on the first active pattern, overlapping the first channel region in a plan view, and constituting a first transistor together with the first active pattern, a first connecting electrode contacting the first conductive region and a second connecting electrode contacting the second conductive region.

A method of manufacturing the transistor substrate according to embodiments of the present disclosure includes forming a first active pattern including a lower layer including an amorphous oxide semiconductor and having a first conductive region, a second conductive region, and a first channel region positioned between the first and second conductive regions, and an upper layer disposed on the lower layer and including a crystalline oxide semiconductor, forming a first gate electrode on the first active pattern, overlapping the first channel region in a plan view, and constituting a first transistor together with the first active pattern, and forming a first connecting electrode contacting the first conductive region and a second connecting electrode contacting the second conductive region.

In an embodiment, forming the first active pattern may include forming the lower layer and the upper layer on the substrate, performing a heat treatment process on the upper layer, forming a gate insulating layer covering the lower layer and the upper layer, removing a portion of the gate insulating layer to form a first-second hole and a second-second hole exposing at least a portion of the lower to the upper layer, forming a conductive layer filling the first-second hole and the second-second hole on the gate insulating layer, and forming photoresist patterns on the conductive layer. A portion exposed by the first-second hole of the lower layer may become the first conductive region and a portion exposed by the second-second hole of the lower layer may become the second conductive region in the forming the first-second hole and the second-second hole.

In an embodiment, after forming the conductive layer, the method may further include removing a portion of each of the conductive layer, the first conductive region, and the second conductive region using the photoresist patterns as a mask to form a first-first hole exposed by the first-second hole and a second-first hole exposed by the second-second hole in the power layer, removing a first portion and a second portion of the gate insulating layer overlapping the first active pattern using the photoresist patterns as a mask, and removing the photoresist patterns. Portions of the lower layer overlapping the first portion and the second portion in the plan view may become the first conductive region and the second conductive region, respectively, and portions of the upper layer overlapping the first portion and the second portion in the plan view may become a third conductive region and a fourth conductive region, respectively in the removing the first portion and the second portion.

In an embodiment, the method may further include forming a second active pattern on the substrate, the second active pattern including an amorphous oxide semiconductor and having a conductive region and a channel region and forming a second gate electrode on the second active pattern, overlapping the channel region in the plan view, and constituting a second transistor together with the second active pattern.

In an embodiment, forming the second active pattern may include forming a preliminary lower layer on the substrate, forming a preliminary upper layer on the preliminary lower layer, removing a portion of the preliminary lower layer to form the lower layer and the second active pattern, and simultaneously removing a portion of the preliminary upper layer to form the upper layer and a residual layer on the second active pattern, removing a portion of the upper layer and an entirety of the residual layer, performing a heat treatment process on the upper layer, forming a gate insulating layer covering the lower layer, the upper layer, and the second active pattern, removing a portion of the gate insulating layer to expose a portion of the lower layer and a portion of the second active pattern, forming a conductive layer on the gate insulating layer, and forming a third photoresist pattern on the conductive layer. An exposed portion of the lower layer may become the first conductive region and the second conductive region and an exposed portion of the second active pattern may become the conductive region when exposing the portion of the lower layer and the portion of the second active pattern.

In an embodiment, forming the lower layer, the second active layer, the upper layer, and the residual layer may include forming a photosensitive organic layer on the preliminary upper layer, exposing and developing the photosensitive organic layer through a halftone mask to form a first photoresist pattern and a second photoresist pattern having different thicknesses, removing a portion of each of the preliminary lower layer using the first photoresist pattern and the second photoresist pattern as masks to form the lower layer, the second active pattern, the upper layer, and the residual layer, and removing a portion of the first photoresist pattern and an entirety of the second photoresist pattern through an ashing process. Removing the portion of the upper layer and the entirety of the residual layer may include removing the portion of the upper layer and the entirety of the residual layer using the first photoresist pattern as a mask and removing the first photoresist pattern. The first photoresist pattern may be formed in an area overlapping the lower layer and the upper layer, and the second photoresist pattern may be formed in an area overlapping the second active pattern and the residual layer.

In an embodiment, after forming the conductive layer, the method may further include removing a portion of each of the conductive layer, the first conductive region, and the second conductive region using the third photoresist pattern as a mask to form a first hole and a second hole in the lower layer and a third hole in the second active pattern, removing a first portion and a second portion of the gate insulating layer overlapping the first active pattern in the plan view and a portion of the gate insulating layer overlapping the second active pattern in the plan view using the third photoresist pattern as a mask, and removing the third photoresist pattern. The first hole may be formed by removing a portion of the first conductive region, the second hole may be formed by removing a portion of the second conductive region, and the third hole may be formed by removing a portion of the conductive region in the forming the first hole, the second hole, and the third hole.

In an embodiment, in removing the first portion and the second portion, portions of the lower layer overlapping the first portion and the second portion in the plan view may become the first conductive region and the second conductive region, respectively, and a portion of the second active pattern overlapping the portion of the gate insulating layer may become the conductive region.

In embodiments of the present disclosure, a transistor of a transistor substrate disposed in a display area may include an active pattern including a lower layer including an amorphous oxide semiconductor and an upper layer including a crystalline oxide semiconductor. In this case, both a driving transistor and a switching transistor of the transistor substrate may have the same structure as the structure of the transistor. In embodiments of the present disclosure, a first transistor of a transistor substrate disposed in the display area may include a first active pattern including a lower layer including an amorphous oxide semiconductor and an upper layer including a crystalline oxide semiconductor, and a second transistor may include a second active pattern having a single-layer structure including an amorphous oxide semiconductor. In this case, a driving transistor of the transistor substrate may have the same structure as the structure of the first transistor, and a switching transistor may have the same structure as the structure of the second transistor. Accordingly, the driving range of the driving transistor may be widened.

### BRIEF DESCRIPTION OF THE DRAWINGS

The above and other features of the present disclosure will become more apparent by describing in detail embodiments thereof with reference to the accompanying drawings.
FIG. 1 is a plan view illustrating a display device according to embodiments of the present disclosure.
FIG. 2 is a circuit diagram illustrating one pixel included in the display device of FIG. 1.
FIG. 3 is a cross-sectional view illustrating an example of a cross-section taken along line I-I' of FIG. 1.
FIG. 4 is a plan view illustrating a transistor substrate of FIG. 3.
FIGS. 5 to 13 are cross-sectional views illustrating a method of manufacturing the transistor substrate of FIG. 3.
FIG. 14 is a cross-sectional view illustrating an example of a cross-section taken along line I-I' of FIG. 1.
FIGS. 15 to 29 are cross-sectional views illustrating a method of manufacturing the transistor substrate of FIG. 3.
FIG. 30 is a cross-sectional view illustrating an example of a cross-section taken along line I-I' of FIG. 1.
FIG. 31 is a block diagram illustrating an electronic device including the display device of FIG. 1.
FIG. 32 is a view illustrating an example of the electronic device of FIG. 31 being implemented as a television.
FIG. 33 is a view illustrating an example of the electronic device of FIG. 31 being implemented as a smartphone.

### DETAILED DESCRIPTION

Embodiments of the present disclosure will be described more fully hereinafter with reference to the accompanying drawings. Like reference numerals may refer to like elements throughout the accompanying drawings.

It will be further understood that terms such as "comprise," "include," and "have," when used herein, specify a presence of stated features, integers, steps, operations, elements, and/or components, but do not preclude the presence or addition of one or more other features, integers, steps, operations, elements, components, and/or groups thereof.

It will be understood that the terms "first," "second," "third," etc. are used herein to distinguish one element from another, and the elements are not limited by these terms. Thus, a "first" element in an embodiment may be described as a "second" element in another embodiment.

It should be understood that descriptions of features or aspects within each embodiment should typically be considered as available for other similar features or aspects in other embodiments, unless the context clearly indicates otherwise.

As used herein, the singular forms "a", "an" and "the" are intended to include the plural forms as well, unless the context clearly indicates otherwise.

Spatially relative terms, such as "beneath", "below", "lower", "under", "above", "upper", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below.

It will be understood that when a component is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. It will also be understood that when a component is referred to as "covering" another component, it can be the only component covering the other component, or one or more intervening components may also be covering the other component. Other words used to describe the relationships between components should be interpreted in a like fashion.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art, for example, within ± 30%, 20%, 10% or 5% of the stated value. Further, it is to be understood that while parameters may be described herein as having "about" a certain value, according to embodiments, the parameter may be exactly the certain value or approximately the certain value within a measurement error as would be understood by a person having ordinary skill in the art. Other uses of these terms and similar terms to describe the relationships between components should be interpreted in a like fashion.

Embodiments of the present disclosure relate to thin-film transistors and display devices incorporating the same, and more particularly, to a novel active pattern structure configured to improve electrical performance and manufacturing uniformity.

In an embodiment, the active pattern of a thin-film transistor includes a lower layer formed of an amorphous oxide semiconductor and an upper layer formed of a crystalline oxide semiconductor. These layers are vertically laminated in a stacked configuration, enabling selective formation of conductive and channel regions in each layer through controlled hydrogen doping. This layered structure allows the lower layer to provide stable baseline conduction while the upper layer, having higher mobility due to its crystallinity, facilitates improved driving characteristics for the display device.

By separating the conductive and channel regions across two oxide semiconductor layers of different crystallinities, the structure according to embodiments can mitigate threshold voltage variation, increase current drive capability, and reduce image artifacts. The resulting improvement in transistor characteristics can improve the performance of high-resolution displays while maintaining compatibility with scalable and cost-effective manufacturing processes.

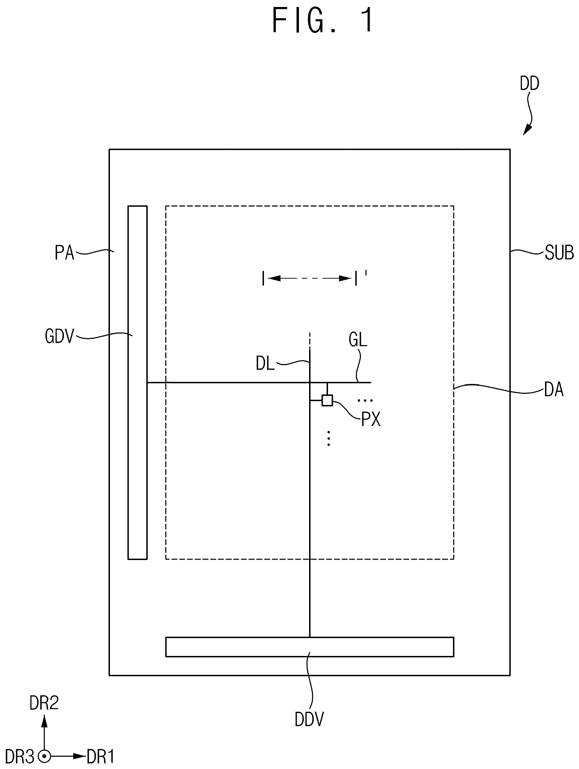

FIG. 1 is a plan view illustrating a display device according to embodiments of the present disclosure.

Referring to FIG. 1, a display device DD according to embodiments of the present disclosure may include a substrate SUB, a plurality of pixels PX, a data line DL, a gate line GL, a gate driver GDV, and a data driver DDV.

The substrate SUB may include a display area DA and a peripheral area PA. The display area DA may be an area capable of displaying an image by generating light or by controlling the transmittance of light provided from an external light source. The peripheral area PA may be an area which does not display an image. The peripheral area PA may be positioned around the display area DA. For example, the peripheral area PA may entirely surround the display area DA.

The plurality of pixels PX may be disposed in the display area DA on the substrate SUB. The plurality of pixels PX may be arranged in a matrix form along a first direction DR1 and a second direction DR2 intersecting the first direction DR1.

Each of the plurality of pixels PX may include a driving element (e.g., a driving thin-film transistor) which generates a driving current, and a light-emitting element which electrically connected to the driving element and generates light based on the driving current. Accordingly, each of the plurality of pixels PX may emit light according to the driving current.

Drivers that drive the plurality of pixels PX may be disposed in the peripheral area PA on the substrate SUB. For example, the drivers may include the gate driver GDV and the data driver DDV.

The gate line GL may be electrically connected to the gate driver GDV and may extend along the first direction DR1. The gate line GL may receive a scan signal from the gate driver GDV and transmit the scan signal to the plurality of pixels PX.

The data line DL may be electrically connected to the data driver DDV and may extend along the second direction DR2. The data line DL may receive a data voltage from the data driver DDV and transmit the data voltage to the plurality of pixels PX.

For example, as illustrated in FIG. 1, in an embodiment, the data driver DDV may be directly disposed on the substrate SUB. In an embodiment, the data driver DDV may be disposed on a circuit board (e.g., a printed circuit board (PCB) or a flexible printed circuit board (FPCB)) electrically connected to pad electrodes disposed on one side of the peripheral area PA.

In this specification, a plane may be defined by the first direction DR1 and the second direction DR2 intersecting the first direction DR1. For example, the first direction DR1 and the second direction DR2 may be perpendicular to each other. In addition, a third direction DR3 may be perpendicular to the plane.

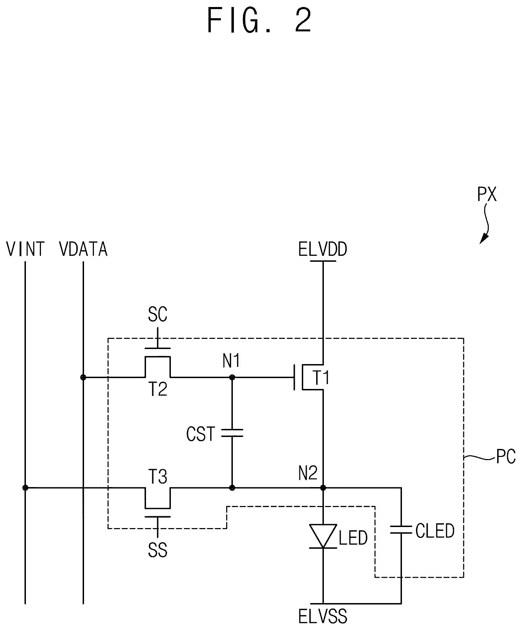

FIG. 2 is a circuit diagram illustrating one pixel included in the display device of FIG. 1.

Referring to FIG. 2, each pixel PX may include a pixel driving circuit part PC and a light-emitting element LED electrically connected to the pixel driving circuit part PC. The pixel driving circuit part PC may generate a driving current, and the light-emitting element LED may generate light based on the driving current.

The pixel driving circuit part PC may include first, second, and third transistors T1, T2, and T3, a storage capacitor CST, and a light-emitting part capacitor CLED.

In an embodiment, the first, second, and third transistors T1, T2, and T3 may all be NMOS transistors. However, embodiments of the present disclosure are not necessarily limited thereto, and at least one of the first, second, and third transistors T1, T2, and T3 may be a PMOS transistor, and the remainder may be NMOS transistors.

In a case in which the pixel driving circuit part PC includes both NMOS and PMOS transistors, an active pattern of the NMOS transistor may include an oxide semiconductor, and an active pattern of the PMOS transistor may include a silicon semiconductor. However, embodiments of the present disclosure are not necessarily limited thereto, and the active pattern of the NMOS transistor may include a silicon semiconductor, and the active pattern of the PMOS transistor may include an oxide semiconductor.

The first transistor T1 may include a first electrode, a gate electrode, and a second electrode. The gate electrode of the first transistor T1 may be connected to a first node N1. A driving voltage ELVDD may be applied to the first electrode of the first transistor T1. The second electrode of the first transistor T1 may be connected to a second node N2. The first transistor T1 may receive the driving voltage ELVDD from a driving voltage line in response to the voltage of the first node N1 and supply the driving current to the light-emitting element LED. For example, the first transistor T1 may be a driving transistor that drives the light-emitting element LED.

The second transistor T2 may include a first electrode, a gate electrode, and a second electrode. A first scan signal SC may be applied to the gate electrode of the second transistor T2. A data voltage VDATA may be applied to the first electrode of the second transistor T2. The second electrode of the second transistor T2 may be connected to the first node N1. The second transistor T2 may be turned on by the first scan signal SC to electrically connect a data line which provides the data voltage VDATA to the first node N1.

The third transistor T3 may include a first electrode, a gate electrode, and a second electrode. A second scan signal SS may be applied to the gate electrode of the third transistor T3. An initialization voltage VINT may be applied to the first electrode of the third transistor T3. The second electrode of the third transistor T3 may be connected to the second node N2. The third transistor T3 may be turned on by the second scan signal SS to electrically connect an initialization voltage line which provides the initialization voltage VINT to the second node N2.

For example, each of the second transistor T2 and the third transistor T3 may be a switching transistor.

In an embodiment, the first electrode of each of the first, second, and third transistors T1, T2, and T3 may be a drain electrode, and the second electrode of each of the first, second, and third transistors T1, T2, and T3 may be a source electrode. However, embodiments of the present disclosure are not necessarily limited thereto, and the first electrode of at least one of the first, second, and third transistors T1, T2, and T3 may be a source electrode, and the second electrodes of the remainder of the first, second, and third transistors T1, T2, and T3 may be drain electrodes.

The storage capacitor CST may include a first electrode and a second electrode. The first electrode of the storage capacitor CST may be connected to the first node N1. The second electrode of the storage capacitor CST may be connected to the second node N2. The storage capacitor CST may store a differential voltage between a gate voltage and a source voltage of the first transistor T1.

The light-emitting part capacitor CLED may include a first electrode and a second electrode. The first electrode of the light-emitting part capacitor CLED may be connected to the second node N2. The second electrode of the light-emitting part capacitor CLED may be connected to a cathode electrode of the light-emitting element LED. The light-emitting part capacitor CLED may enable the voltage at both ends of the light-emitting element LED to be maintained constant, thereby enabling the light-emitting element LED to display a constant brightness. In an embodiment, the light-emitting part capacitor CLED may be omitted.

The light-emitting element LED may include an anode electrode and a cathode electrode. The anode electrode of the light-emitting element LED may be connected to the second node N2. A common voltage ELVSS may be applied to the cathode electrode of the light-emitting element LED. The common voltage ELVSS may have a voltage level lower than a voltage level of the driving voltage ELVDD. The light-emitting element LED may emit light with luminance corresponding to the driving current provided from the pixel driving circuit part PC.

In FIG. 2, the pixel driving circuit part PC is shown as including three transistors and two capacitors, but embodiments of the present disclosure are not necessarily limited thereto.

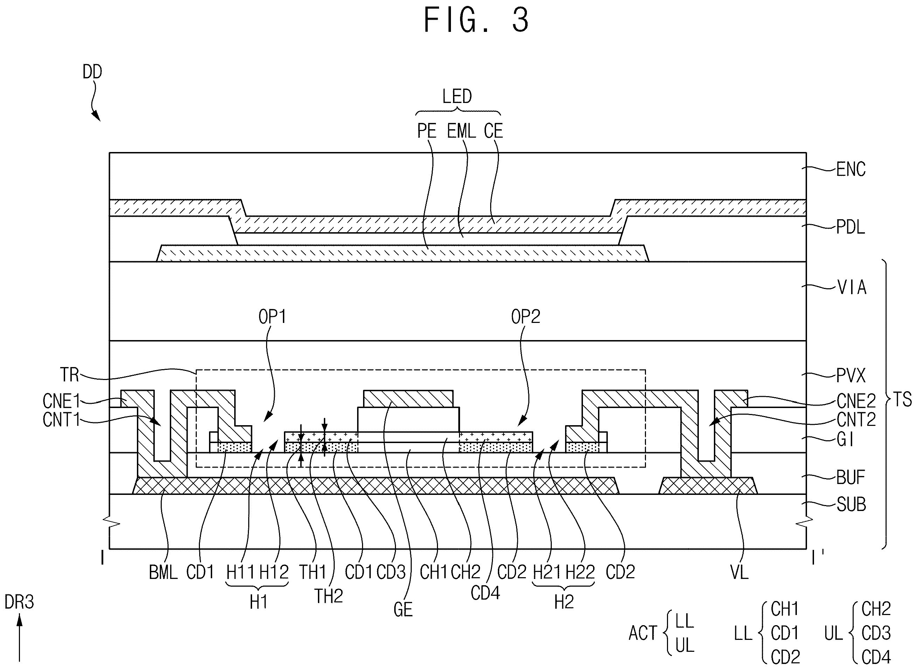

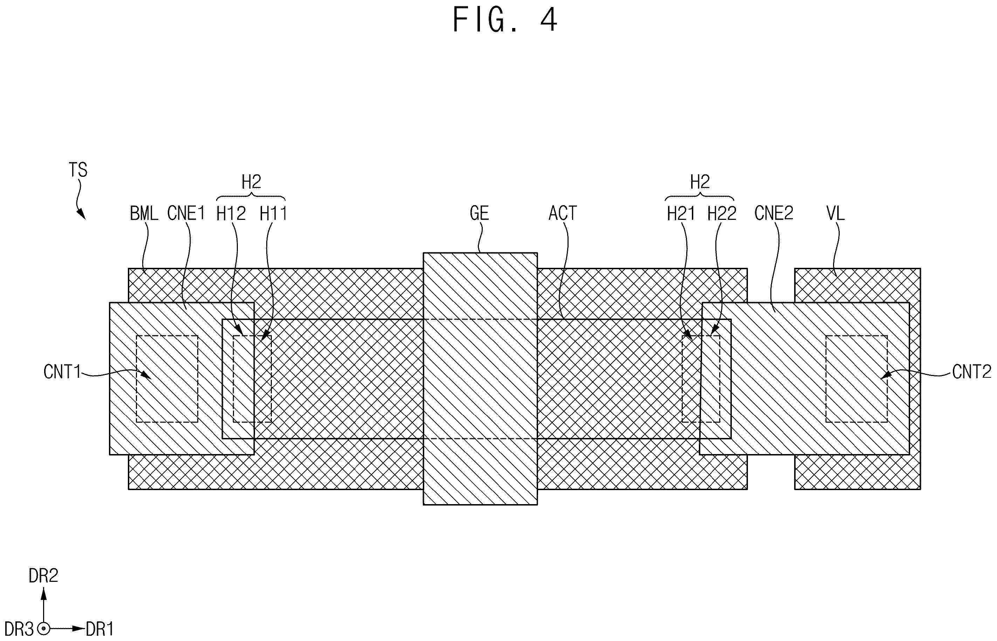

FIG. 3 is a cross-sectional view illustrating an example of a cross-section taken along line I-I' of FIG. 1. FIG. 4 is a plan view illustrating a transistor substrate of FIG. 3. For example, FIG. 3 is a cross-sectional view illustrating a portion of the display area DA of FIG. 1.

Referring to FIGS. 3 and 4, the display device DD according to embodiments of the present disclosure may include a transistor substrate TS, a pixel defining layer PDL, the light-emitting element LED, and an encapsulation layer ENC sequentially disposed on the substrate SUB.

The transistor substrate TS may include a voltage line VL, a lower metal layer BML, a buffer layer BUF, a gate insulating layer GI, a transistor TR, first and second connecting electrodes CNE1 and CNE2, a passivation layer PVX, and a via insulating layer VIA. Here, the transistor TR may include an active pattern ACT and a gate electrode GE. In addition, the light-emitting element LED may include a pixel electrode PE, a light-emitting layer EML, and a common electrode CE.

The substrate SUB may be, for example, a glass substrate, a metal substrate, or a polymer substrate. In an embodiment, the substrate SUB may be a flexible polymer substrate. However, embodiments of the present disclosure are not necessarily limited thereto, and the substrate SUB may be an inorganic layer, an organic layer, or a composite material layer.

The lower metal layer BML may be disposed on the substrate SUB. The lower metal layer BML may block external light incident on the transistor TR. The lower metal layer BML may transmit signals and/or voltages to the transistor TR. For example, the lower metal layer BML may include a metal, an alloy, a metal nitride, a conductive metal oxide, a transparent conductive material, and the like. These can be used alone or in combination with each other.

The voltage line VL may be disposed on the substrate SUB. The voltage line VL may be disposed in the same layer as the lower metal layer BML. That is, the voltage line VL may include the same material as the lower metal layer BML and may be formed through the same process. Various voltages (e.g., the driving voltage ELVDD or the data voltage DATA shown in FIG. 2) may be applied to the voltage line VL.

The buffer layer BUF may be disposed on the substrate SUB. The buffer layer BUF may cover the lower metal layer BML and the voltage line VL. The buffer layer BUF may prevent metal atoms or impurities from diffusing from the substrate SUB into the transistor TR. In addition, the buffer layer BUF may improve the flatness of the surface of the substrate SUB if the surface of the substrate SUB is not uniform. For example, the buffer layer BUF may include a silicon compound such as silicon oxide (SiOₓ), silicon nitride (SiNₓ), silicon oxynitride (SiOₓN_{y}), and the like. These can be used alone or in combination with each other.

The active pattern ACT may be disposed on the buffer layer BUF. The active pattern ACT may include a metal oxide semiconductor. In an embodiment, the active pattern ACT may include a lower layer LL including an amorphous oxide semiconductor and an upper layer UL disposed on the lower layer LL and including a crystalline oxide semiconductor. Accordingly, the driving range of the driving transistor (e.g., the first transistor T1 in FIG. 2) may be widened.

In this configuration, in an embodiment, the lower layer LL including an amorphous oxide semiconductor may provide manufacturing benefits due to its relatively low processing temperature and good uniformity across large substrates. The upper layer UL, formed of a crystalline oxide semiconductor, may contribute to improved charge mobility and improved electrical performance of the transistor. The integration of these two layers into a stacked active pattern ACT may enable the transistor to benefit from both process stability and improved operational characteristics, for example, when used as a driving transistor in an active matrix display.

For example, the crystalline oxide semiconductor of the lower layer LL may include zinc oxide (ZnOₓ), gallium oxide (GaOₓ), tin oxide (SnOₓ), indium oxide (InOₓ), indium gallium oxide (IGO), indium zinc oxide (IZO), indium tin oxide (ITO), indium zinc tin oxide (IZTO), indium gallium zinc oxide (IGZO), and the like containing indium (In), zinc (Zn), gallium (Ga), tin (Sn), titanium (Ti), aluminum (Al), hafnium (Hf), zirconium (Zr), magnesium (Mg), and the like. These can be used alone or in combination with each other. In an embodiment, the crystalline oxide semiconductor of the lower layer LL may include indium gallium zinc oxide (IGZO). However, embodiments of the present disclosure are not necessarily limited thereto.

Similarly, the amorphous oxide semiconductor of the upper layer UL may include, for example, zinc oxide (ZnOₓ), gallium oxide (GaOₓ), tin oxide (SnOₓ), indium oxide (InOₓ), indium gallium oxide (IGO), indium zinc oxide (IZO), indium tin oxide (ITO), indium zinc tin oxide (IZTO), indium gallium zinc oxide (IGZO), and the like including, for example, indium (In), zinc (Zn), gallium (Ga), tin (Sn), titanium (Ti), aluminum (Al), hafnium (Hf), zirconium (Zr), magnesium (Mg), and the like. These can be used alone or in combination with each other. In an embodiment, the amorphous oxide semiconductor of the upper layer UL may include indium gallium oxide (IGO). However, embodiments of the present disclosure are not necessarily limited thereto.

The lower layer LL may have a first channel region CH1, a first conductive region CD1, and a second conductive region CD2. The first channel region CH1 may be positioned between the first conductive region CD1 and the second conductive region CD2. For example, the first and second conductive regions CD1 and CD2 may be regions conductive as n+ type. However, embodiments of the present disclosure are not necessarily limited thereto. The first channel area CH1 may be a non-conductive region.

The upper layer UL may have a second channel region CH2, a third conductive region CD3, and a fourth conductive region CD4. The second channel region CH2 may be positioned between the third conductive region CD3 and the fourth conductive region CD4. The second channel region CH2 may overlap the first channel region CH1 in the plan view, and the third and fourth conductive regions CD3 and CD4 may at least partially overlap the first and second conductive regions CD1 and CD2, respectively, in the plan view. For example, the third and fourth conductive regions CD3 and CD4 may be regions conductive as n+ type. However, embodiments of the present disclosure are not necessarily limited thereto. The second channel area CH2 may be a non-conductive region.

In an embodiment, by vertically aligning the first and second channel regions CH1 and CH2, and configuring the conductive regions CD3 and CD4 in the upper layer UL to at least partially overlap the underlying first and second conductive regions CD1 and CD2, the resulting structure can suppress parasitic resistance and improve carrier injection efficiency. This alignment may help stabilize the threshold voltage and contribute to the consistent operation of the driving transistor under varying load conditions in the display.

In an embodiment, a width of the lower layer LL may be substantially the same as a width of the upper layer UL. Here, the width refers to a length in the first direction DR1. That is, end portions of the lower layer LL facing in the first direction DR1 may coincide with end portions of the upper layer UL facing in the first direction DR1.

A first-first hole H11 and a second-first hole H21 exposing at least a portion of an upper surface of the buffer layer BUF may be defined in the lower layer LL. The first-first hole H11 may be surrounded by the first conductive region CD1, and the second-first hole H21 may be surrounded by the second conductive region CD2. That is, the first conductive area CD1 may have a planar shape surrounding the first-first hole H11, and the second conductive area CD2 may have a planar shape surrounding the second-first hole H21.

A first-second hole H12 connected to the first-first hole H11 and a second-second hole H22 connected to the second-first hole H21 may be defined in the upper layer UL. The first-second hole H12 may expose a portion of the first conductive region CD1 and the first-first hole H11, and the second-second hole H22 may expose a portion of the second conductive region CD2 and the second-first hole H21. The first-first hole H11 and the first-second hole H12 may define a first hole H1, and the second-first hole H21 and the second-second hole H22 may define a second hole H2.

In an embodiment, a width of the first-second hole H12 may be greater than a width of the first-first hole H11, and a width of the second-second hole H22 may be greater than a width of the second-first hole H21. That is, the first-second hole H12 may expose an entirety of the first-first hole H11, and the second-second hole H22 may expose an entirety of the second-first hole H21. Here, the width refers to a length in the first direction DR1.

A thickness TH1 of the lower layer LL may be more than about 50 angstroms (Å). For example, the thickness TH1 of the lower layer LL may be in a range of more than about 50 Å and less than about 300 Å. If the thickness TH1 of the lower layer LL is less than or equal to about 50 Å, etching of the lower layer LL may not be easy. In this case, there may be difficulty in forming the active pattern ACT. If the thickness TH1 of the lower layer LL is more than or equal to about 300 Å, process characteristics may deteriorate.

In an embodiment, a thickness TH2 of the upper layer UL may be less than about 100 Å. For example, the thickness TH2 of the upper layer UL may be in a range of more than about 20 Å and less than about 100 Å. If the thickness TH2 of the upper layer UL is less than or equal to about 20 Å, crystal growth may not proceed smoothly, and current flow through the upper layer UL may not proceed smoothly. If the thickness TH2 of the upper layer UL is more than about 100 Å, process characteristics may deteriorate.

In an embodiment, the relative thicknesses of the upper and lower layers are selected to improve the balance between carrier mobility and uniform film deposition. A thinner upper layer UL may facilitate effective crystallization during annealing and maintain low leakage current, while the lower layer LL, being slightly thicker, may provide structural stability and compatibility with standard backplane processes. These parameters may collectively contribute to a transistor configuration that supports both improved electrical characteristics and scalable manufacturing.

The gate insulating layer GI may be disposed on the buffer layer BUF and the active pattern ACT. The gate insulating layer GI may cover at least a portion of the active pattern ACT. A first opening OP1 connected to the first hole H1 and a second opening OP2 connected to the second hole H2 may be defined in the gate insulating layer GI. For example, the first opening OP1 may expose the first hole H1 and the third conductive region CD3, and the second opening OP2 may expose the second hole H2 and the fourth conductive region CD4.

For example, the gate insulating layer GI may include a silicon compound such as silicon oxide (SiOₓ), silicon nitride (SiNₓ), silicon oxynitride (SiOₓN_{y}), and the like. These can be used alone or in combination with each other.

The gate electrode GE may be disposed on the gate insulating layer GI. The gate electrode GE may overlap the first channel area CH1 and the second channel area CH2 in the plan view. For example, the gate electrode GE may include a metal, an alloy, a metal nitride, a conductive metal oxide, a transparent conductive material, and the like. Examples of the metal may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), and the like. Examples of the conductive metal oxide may include indium tin oxide, indium zinc oxide, and the like. Examples of the metal nitride may include aluminum nitride (AlNₓ), tungsten nitride (WNₓ), chromium nitride (CrNₓ), and the like. These materials may be used alone or in combination.

The first connecting electrode CNE1 and the second connecting electrode CNE2 may be disposed on the gate insulating layer GI. The first connecting electrode CNE1 and the second connecting electrode CNE2 may face each other in the first direction DR1.

The first connecting electrode CNE1 may be connected (or in contact) with the lower metal layer BML through a first contact hole CNT1 penetrating the buffer layer BUF and the gate insulating layer GI, and the second connecting electrode CNE2 may be connected (or in contact) with the voltage line VL through a second contact hole CNT2 penetrating the buffer layer BUF and the gate insulating layer GI.

The first connecting electrode CNE1 may be connected (or in contact) with the first conductive region CD1 through the first opening OP1 and the first-second hole H12, and the second connecting electrode CNE2 may be connected (or in contact) with the second conductive region CD2 through the second opening OP2 and the second-second hole H22. That is, the first connecting electrode CNE1 may extend into the inside the first opening OP1 and the first-second hole H12, and may not extend into the inside the first-first hole H11. The second connecting electrode CNE2 may extend into the inside the second opening OP2 and the second-second hole H22, and may not extend into the inside the first-second hole H12. In this case, the first connecting electrode CNE1 may contact the upper layer UL inside the first-second hole H12, and the second connecting electrode CNE2 may contact the upper layer UL inside the second-second hole H22.

Accordingly, the first connecting electrode CNE1 may electrically connect the lower metal layer BML and the active pattern ACT, and the second connecting electrode CNE2 may electrically connect the voltage line VL and the active pattern ACT.

In an embodiment, the first connecting electrode CNE1 and the second connecting electrode CNE2 may be disposed in the same layer as the gate electrode GE. That is, the first connecting electrode CNE1 and the second connecting electrode CNE2 may include the same material as the gate electrode GE and may be formed through the same process.

In an embodiment, the transistor TR may correspond to the first, second, and third transistors T1, T2, and T3 of FIG. 2. That is, the first, second, and third transistors T1, T2, and T3 of FIG. 2 may all have the structure of the transistor TR. However, embodiments of the present disclosure are not necessarily limited thereto.

The passivation layer PVX may be disposed on the gate insulating layer GI, the gate electrode GE, the first connecting electrode CNE1, and the second connecting electrode CNE2. The passivation layer PVX may cover the gate insulating layer GI, the gate electrode GE, the first connecting electrode CNE1, and the second connecting electrode CNE2, and may fill the first and second holes H1 and H2 and the first and second openings OP1 and OP2. For example, the passivation layer PVX may include a silicon compound such as silicon oxide (SiOₓ), silicon nitride (SiNₓ), silicon oxynitride (SiOₓN_{y}), and the like. These can be used alone or in combination with each other.

The via insulating layer VIA may be disposed on the passivation layer PVX. The via insulating layer VIA may have a substantially flat upper surface. The via insulating layer VIA may include an organic material. For example, the via insulating layer VIA may include an organic material such as phenolic resin, polyacrylates resin, polyimides resin, polyamides resin, siloxane resin, epoxy resin, and the like. These can be used alone or in combination with each other.

The pixel electrode PE may be disposed on the via insulating layer VIA. If the transistor TR corresponds to the first transistor T1 of FIG. 2, the pixel electrode PE may be connected to the first connecting electrode CNE1 through a contact hole penetrating the via insulating layer VIA. For example, the pixel electrode PE may include a metal, an alloy, a metal nitride, a conductive metal oxide, a transparent conductive material, and the like. These can be used alone or in combination with each other. In an embodiment, the pixel electrode PE may have a stacked structure including ITO/Ag/ITO. However, embodiments of the present disclosure are not necessarily limited thereto. The pixel electrode PE may be an anode electrode.

The pixel defining layer PDL may be disposed on the via insulating layer VIA. The pixel defining layer PDL may cover an edge of the pixel electrode PE. The pixel defining layer PDL may define an opening exposing at least a portion of an upper surface of the pixel electrode PE. For example, the pixel defining layer PDL may include an inorganic material or an organic material. In an embodiment, the pixel defining layer PDL may include an organic material such as, for example, epoxy resin, siloxane resin, and the like. These can be used alone or in combination with each other. In an embodiment, the pixel defining layer PDL may include an inorganic material and/or an organic material containing a light-blocking material such as a black pigment, black dye, and the like.

The light-emitting layer EML may be disposed on the pixel electrode PE. For example, the light-emitting layer EML may be disposed in the opening of the pixel defining layer PDL. The light-emitting layer EML may include a light-emitting material which emits light of a preset color. For example, the light-emitting layer EML may include a light-emitting material which emits red light, green light, or blue light.

The common electrode CE may be disposed on the pixel defining layer PDL and the light-emitting layer EML. For example, the common electrode CE may include a metal, an alloy, a metal nitride, a conductive metal oxide, a transparent conductive material, and the like. These can be used alone or in combination with each other. The common electrode CE may be a cathode electrode.

Accordingly, the light-emitting element LED including the pixel electrode PE, the light-emitting layer EML, and the common electrode CE, and may be formed in the display area DA on the substrate SUB. The light-emitting element LED may be electrically connected to the transistor TR. Accordingly, the light-emitting element LED may receive a driving signal from the transistor TR and generate light based on the driving signal.

The encapsulation layer ENC may be disposed on the common electrode CE. The encapsulation layer ENC may protect the light-emitting element LED from foreign substances such as moisture and oxygen. For example, the encapsulation layer ENC may include at least one inorganic layer and at least one organic layer. In an embodiment, the encapsulation layer ENC may have a stacked structure of a first inorganic layer, an organic layer, and a second inorganic layer. However, embodiments of the present disclosure are not necessarily limited thereto.

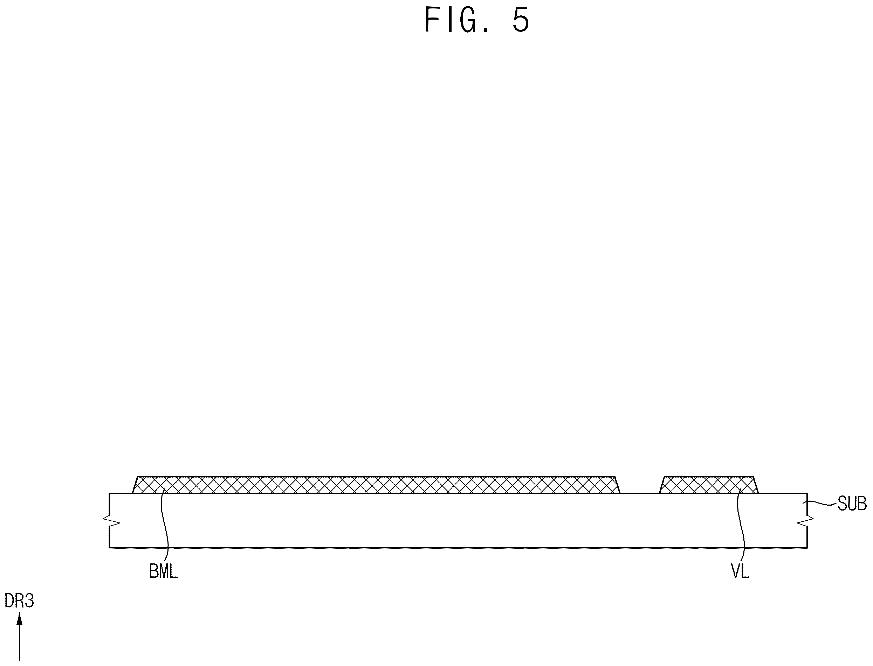

FIGS. 5 to 13 are cross-sectional views illustrating a method of manufacturing the transistor substrate of FIG. 3. Hereinafter, overlapping contents with respect to the transistor substrate TS described with reference to FIGS. 3 and 4 will be omitted or simplified.

Referring to FIG. 5, the lower metal layer BML and the voltage line VL may be formed on the substrate SUB. The lower metal layer BML and the voltage line VL may be formed simultaneously through the same process.

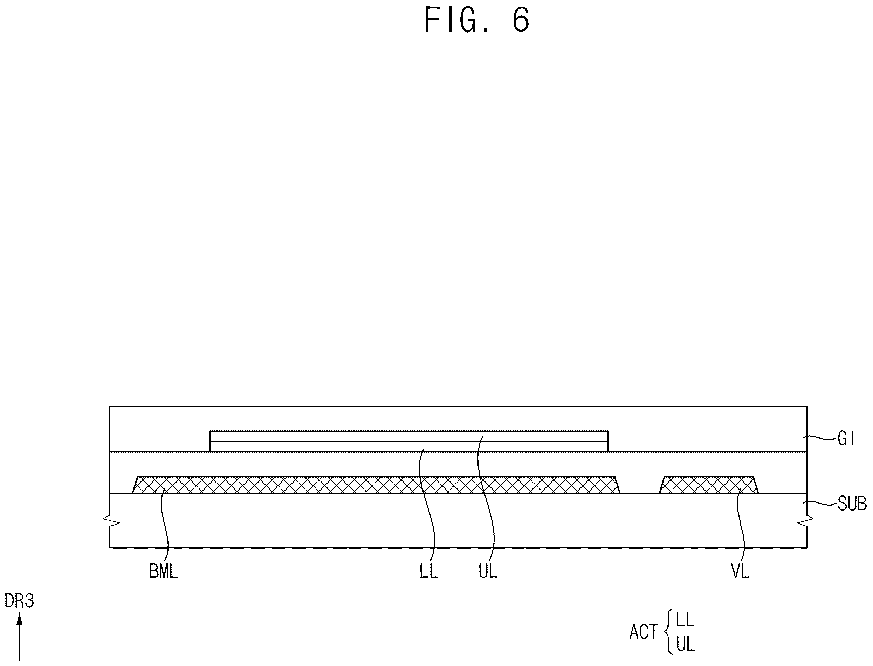

Referring to FIG. 6, the buffer layer BUF may be formed on the substrate SUB. The buffer layer BUF may cover the lower metal layer BML and the voltage line VL. For example, the buffer layer BUF may be formed using a silicon compound.

The active pattern ACT may be formed on the buffer layer BUF. The active pattern ACT may include the lower layer LL disposed on the buffer layer BUF and the upper layer UL disposed on the lower layer LL. For example, a semiconductor layer may be entirely formed on the buffer layer BUF, and the active pattern ACT may be formed by patterning the semiconductor layer. In an embodiment, each of the lower layer LL and the upper layer UL may be formed using a metal oxide semiconductor. For example, the lower layer LL may be formed using indium gallium zinc oxide (IGZO), and the upper layer UL may be formed using indium gallium oxide (IGO).

After forming the active pattern ACT, a heat treatment process may be performed on the upper layer UL of the active pattern ACT. Accordingly, the upper layer UL may have a crystalline structure. That is, the upper layer UL may include a crystalline oxide semiconductor. In contrast, the lower layer LL may include an amorphous oxide semiconductor.

The gate insulating layer GI may be formed on the buffer layer BUF. The gate insulating layer GI may cover the active pattern ACT. For example, the gate insulating layer GI may be formed using a silicon compound.

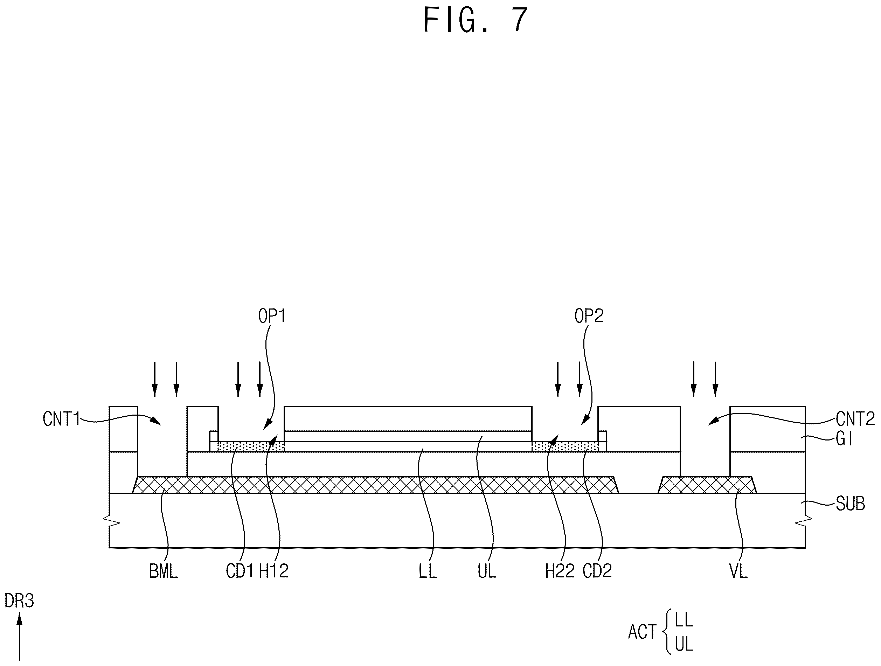

Referring to FIG. 7, through a first etching process, a portion of each of the buffer layer BUF, the gate insulating layer GI, and the upper layer UL may be removed. Accordingly, a first contact hole CNT1 exposing at least a portion of the lower metal layer BML and a second contact hole CNT2 exposing at least a portion of the voltage line VL may be formed in the buffer layer BUF and the gate insulating layer GI. At substantially the same time, the first-second hole H12 and the second-second hole H22 may be formed in the upper layer UL, and the first opening OP1 overlapping the first-second hole H12 and the second opening OP2 overlapping the second-second hole H22 may be formed in the gate insulating layer GI.

For example, the first etching process may be a dry etching process. However, embodiments of the present disclosure are not necessarily limited thereto.

During the process of removing the portion of the gate insulating layer GI through the first etching process, hydrogen included in the gate insulating layer GI may flow into the lower layer LL. The portion of the lower layer LL into which hydrogen is introduced from the gate insulating layer GI may have a high carrier concentration due to the introduced hydrogen, thereby have conductivity, and thus may become the first conductive region CD1 and the second conductive region CD2. The first conductive region CD1 may be exposed by the first-second hole H12, and the second conductive region CD2 may be exposed by the second-second hole H22.

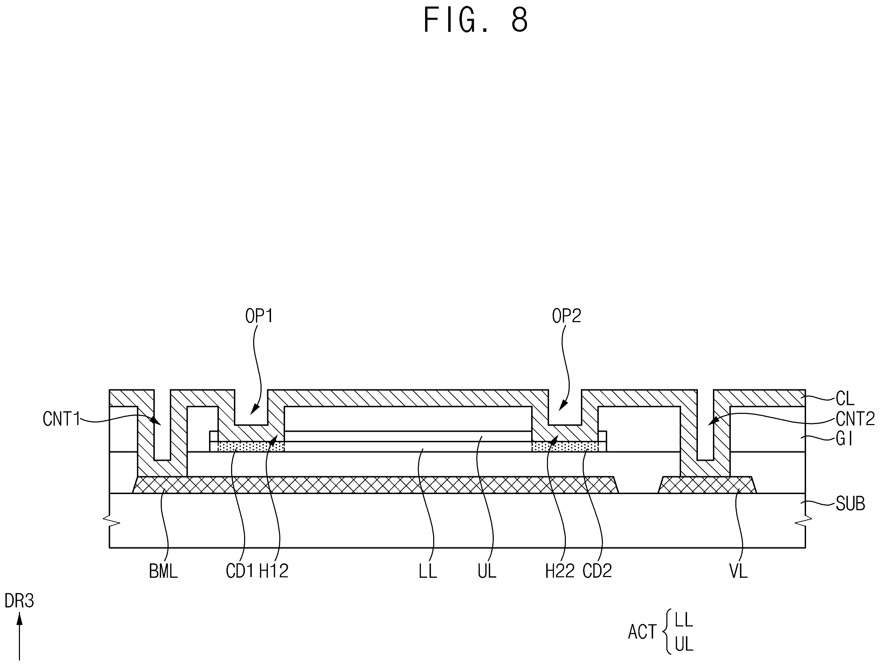

Referring to FIG. 8, a conductive layer CL may be entirely formed on the gate insulating layer GI. The conductive layer CL may fill the first and second contact holes CNT1 and CNT2, the first and second openings OP 1 and OP2, and the first-second and second-second holes H12 and H22. For example, the conductive layer CL may be formed using a metal, an alloy, a metal nitride, a conductive metal oxide, a transparent conductive material, and the like.

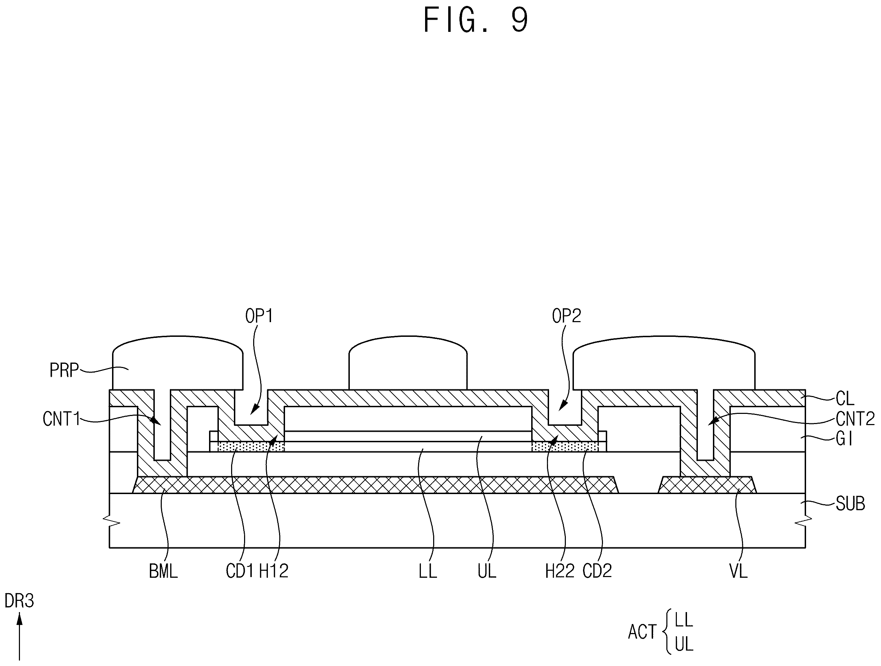

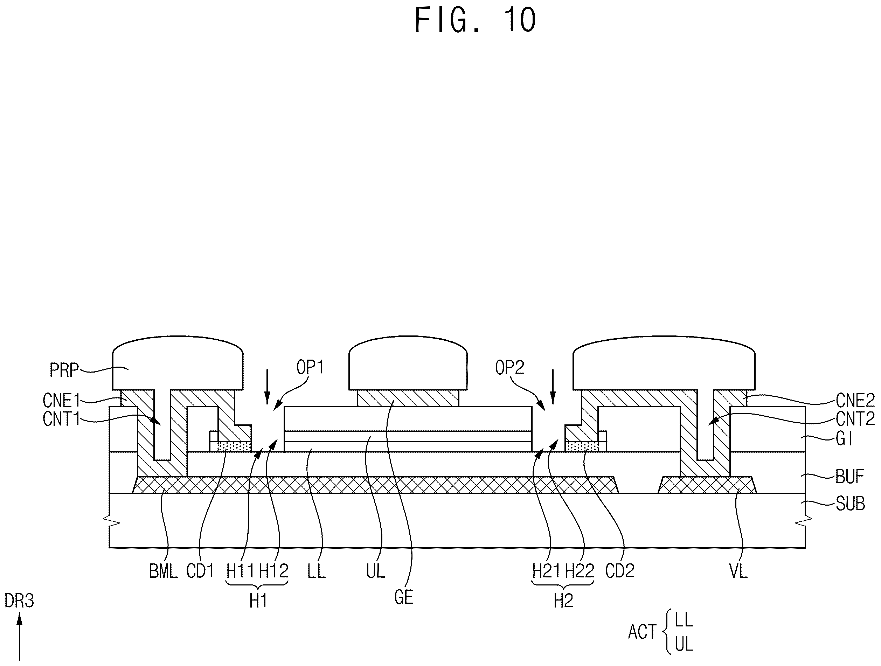

Referring to FIGS. 9 and 10, a photosensitive organic layer may be formed on the conductive layer CL. A plurality of photoresist patterns PRP may be formed by exposing and developing the photosensitive organic layer. The photoresist patterns PRP may overlap areas where the first connecting electrode CNE1, the gate electrode GE, and the second connecting electrode CNE2 are to be formed, respectively.

For example, in an embodiment, the photoresist patterns PRP may include positive photoresist. In an embodiment, the photoresist patterns PRP may include negative photoresist.

Through a second etching process using the photoresist patterns PRP as a mask, a portion of the first conductive region CD1, a portion of the second conductive region CD2, and a portion of the conductive layer CL may be removed. For example, the portion of the first conductive region CD1, the portion of the second conductive region CD2, and the portion of the conductive layer CL which do not overlap the photoresist patterns PRP may be removed through the second etching process.

In an embodiment, the second etching process, which removes exposed portions of the conductive layer CL and the underlying first and second conductive regions CD1 and CD2, may contribute to the formation of stacked hole structures. For example, this operation may facilitate the creation of the first-first hole H11 and the second-first hole H21 within the first and second conductive regions CD1 and CD2, respectively. These stacked holes may enable subsequent electrical connection to be formed selectively within the upper layer UL, while electrically isolating portions of the lower layer LL that serve as the channel regions. This spatial separation between conductive and non-conductive regions within a vertically stacked semiconductor structure may result in improved device reliability.

Accordingly, the first connecting electrode CNE1 filling the first contact hole CNT1 and connected to the first conductive region CD1, the gate electrode GE overlapping a center portion of the active pattern ACT in the plan view, and the second connecting electrode CNE2 filling the second contact hole CNT2 and connected to the second conductive region CD2 may be formed simultaneously. At substantially the same time, the portion of the first conductive region CD1 which does not overlap the photoresist patterns PRP may be removed to form the first-first hole H11, and the portion of the second conductive region CD2 that does not overlap the photoresist patterns PRP may be removed to form the second-first hole H21.

In an embodiment, by patterning the first connecting electrode CNE1, the gate electrode GE, and the second connecting electrode CNE2 in a single process using the same conductive layer CL, the fabrication sequence may avoid additional alignment operations, thus improving process integration and yield. Further, the simultaneous formation of the vertically aligned hole structures and contact electrodes may allow for tight registration between the gate electrode GE and the center of the active pattern ACT. This alignment may improve electrostatic control over the dual-channel configuration formed in the active pattern ACT and support improved subthreshold characteristics in the resulting thin-film transistor TR.

For example, the second etching process may be a wet etching process. However, embodiments of the present disclosure are not necessarily limited thereto.

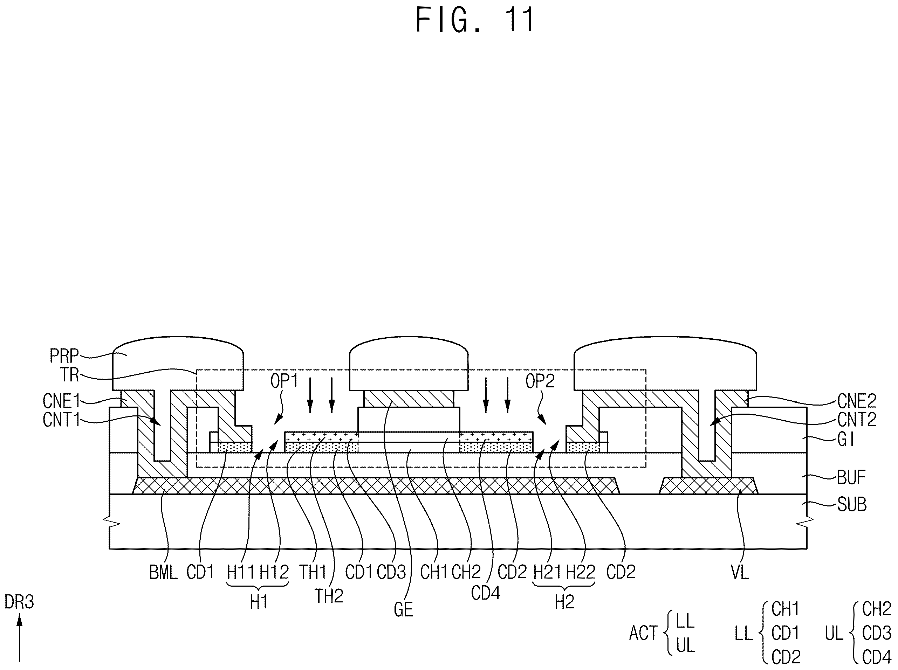

Referring to FIGS. 10 and 11, through a third etching process using the photoresist patterns PRP as a mask, a portion of the gate insulating layer GI may be removed. For example, through the third etching process, a first portion and a second portion of the gate insulating layer GI not overlapping the photoresist patterns PRP but overlapping the active pattern ACT in the plan view may be removed. Accordingly, the width of each of the first opening OP1 and the second opening OP2 may be expanded.

In an embodiment, the expansion of the first and second openings OP1 and OP2 through the third etching process may increase the surface area through which hydrogen from the gate insulating layer GI can diffuse into the active pattern ACT. This may enable a broader and more uniform distribution of dopant species within both the lower layer LL and the upper layer UL. As a result, the third etching operation may not only support further geometric refinement of the hole structure, but may also contribute to the modulation of electrical properties in the contact and channel regions of the transistor TR.

For example, the third etching process may be a dry etching process. However, embodiments of the present disclosure are not necessarily limited thereto.

During the process of removing the portion of the gate insulating layer GI through the third etching process, hydrogen included in the gate insulating layer GI may flow into the lower layer LL and the upper layer UL. The portion of the lower layer LL into which hydrogen is introduced from the gate insulating layer GI may have a high carrier concentration due to the introduced hydrogen, thereby have conductivity, and thus may become the first conductive region CD1 and the second conductive region CD2. Likewise, the portion of the upper layer UL into which hydrogen is introduced from the gate insulating layer GI may have a high carrier concentration due to the introduced hydrogen, thereby have conductivity, and thus may become the third conductive region CD3 and the fourth conductive region CD4. That is, after performing the third etching process, the portions of the lower layer LL overlapping the first portion and the second portion of the gate insulating layer GI in the plan view may become the first conductive area CD1 and the second conductive area CD2, respectively, and the portions of the upper layer UL overlapping the first portion and the second portion of the gate insulating layer GI in the plan view may become the third conductive area CD3 and the fourth conductive area CD4, respectively.

In an embodiment, the formation of the third and fourth conductive regions CD3 and CD4 within the upper layer UL, in addition to the first and second conductive regions CD1 and CD2 within the lower layer LL, may result in a complex vertical structure in which both crystalline and amorphous regions of the oxide semiconductor can participate in electrical conduction. This vertically distributed doping profile may support the use of stacked contact geometries while also reducing the likelihood of contact resistance at the electrode interface. Moreover, this configuration may allow for channel conduction pathways to be vertically confined between selectively doped contact regions, providing improved isolation and control over short-channel effects.

Accordingly, the first conductive region CD1 may be formed to surround the first-first hole H11, and the second conductive region CD2 may be formed to surround the second-first hole H21.

In an embodiment, the configuration in which the first and second conductive regions CD1 and CD2 surround the first-first hole H11 and the second-first hole H21, respectively, allows the contact electrodes CNE1 and CNE2 to interface with the upper layer UL while remaining electrically isolated from adjacent portions of the lower layer LL. This structural arrangement may reduce lateral current leakage across the active pattern ACT and support high field-effect mobility within the channel regions. Further, this selective vertical contact configuration may simplify integration of the dual-layer active structure with other display elements by providing robust electrode coupling without requiring complex multi-layer interconnects.

In this case, the portion of the lower layer LL into which hydrogen does not flow may become the first channel region CH1, and the portion of the upper layer UL into which hydrogen does not flow may become the second channel region CH2.

In an embodiment, the formation of distinct channel regions in both the lower layer LL and the upper layer UL, e.g., the first channel region CH1 and the second channel region CH2, may enable dual-channel conduction behavior, which can be utilized to tailor transistor characteristics such as, for example, threshold voltage, transconductance, and drive current. By relying on undoped regions of both oxide semiconductor layers, the transistor TR can exhibit improved on/off current ratios and reduced variability across large-area substrates. This layered channel structure may also facilitate fine control of turn-on characteristics and suppress variability due to process-induced defects in a single layer.

Accordingly, the transistor TR including the active pattern ACT including the lower layer LL and the upper layer UL and the gate electrode GE on the active pattern ACT may be formed. That is, the gate electrode GE may constitute the transistor TR together with the active pattern ACT.

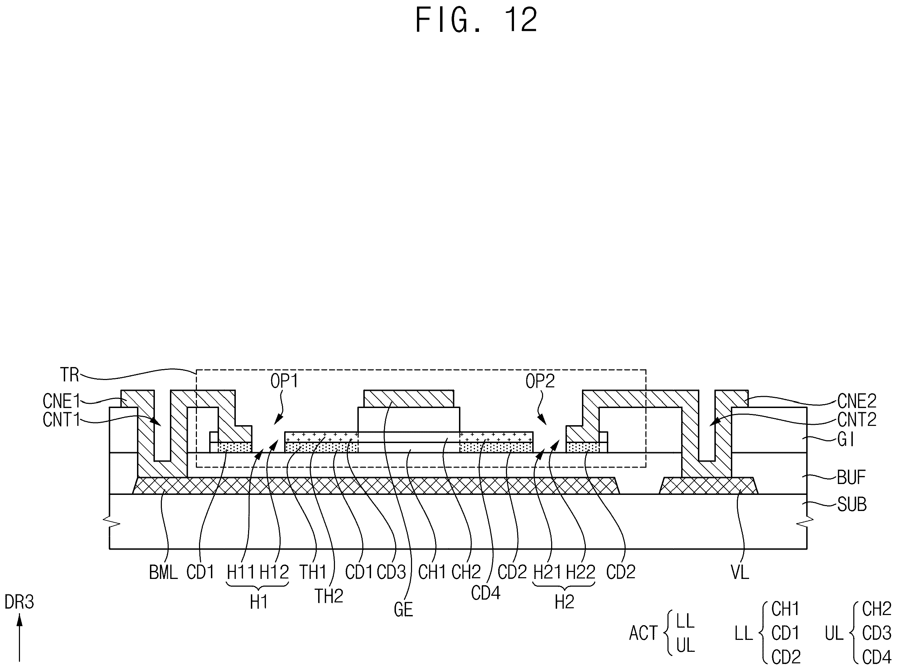

Referring to FIG. 12, after the transistor TR is formed, the photoresist patterns PRP may be removed.

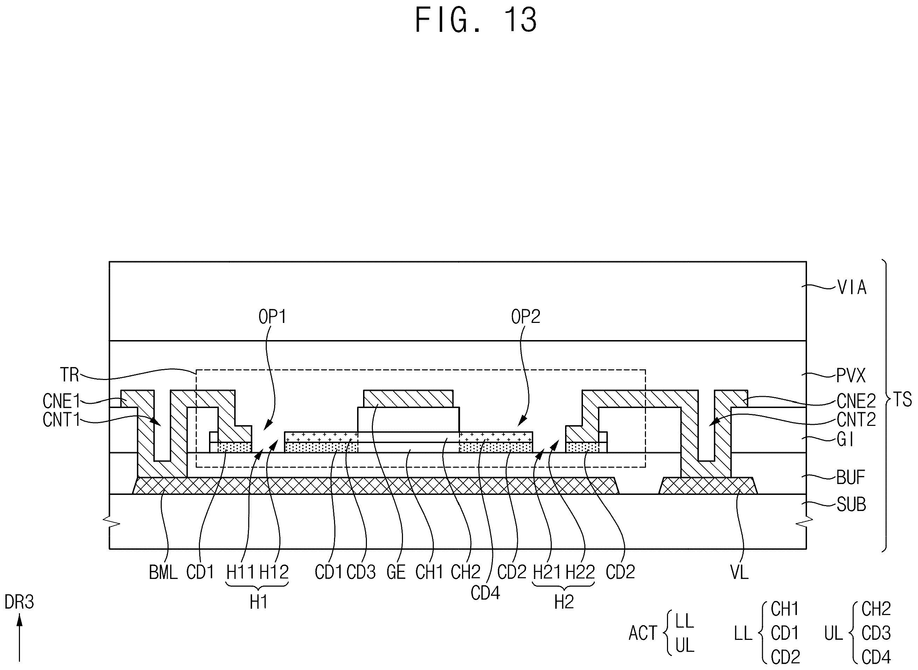

Referring to FIG. 13, the passivation layer PVX may be formed on the gate insulating layer GI, the gate electrode GE, the first connecting electrode CNE1, and the second connecting electrode CNE2. For example, the passivation layer PVX may be formed using a silicon compound.

The via insulating layer VIA may be formed on the passivation layer PVX. The via insulating layer VIA may be formed using an organic material. Through a chemical mechanical polishing process, the via insulating layer VIA may have a substantially flat upper surface.

Accordingly, the transistor substrate TS including the voltage line VL, the lower metal layer BML, the buffer layer BUF, the gate insulating layer GI, the transistor TR, the first connecting electrode CNE1, the second connecting electrode CNE2, the passivation layer PVX, and the via insulating layer VIA may be manufactured.

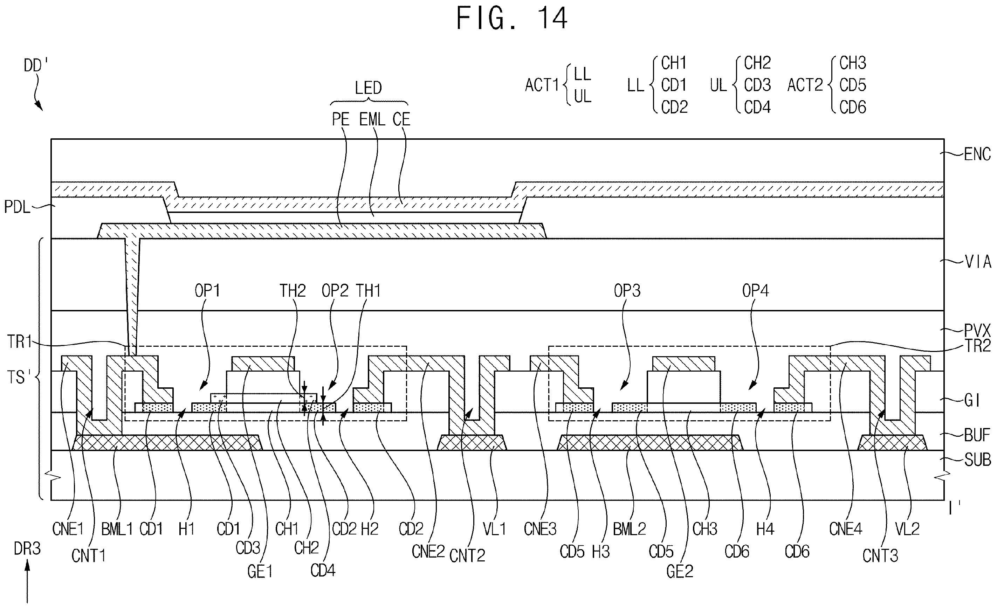

FIG. 14 is a cross-sectional view illustrating an example of a cross-section taken along line I-I' of FIG. 1.

Referring to FIG. 14, a display device DD' according to an embodiment of the present disclosure may include a transistor substrate TS', a pixel defining layer PDL, a light-emitting element LED, and an encapsulation layer ENC sequentially disposed on a substrate SUB.

The transistor substrate TS' may include a first voltage line VL1, a second voltage line VL2, a first lower metal layer BML1, a second lower metal layer BML2, a buffer layer BUF, a gate insulating layer GI, a first transistor TR1, a second transistor TR2, a first connecting electrode CNE1, a second connecting electrode CNE2, a third connecting electrode CNE3, a fourth connecting electrode CNE4, a passivation layer PVX, and a via insulating layer VIA. The first transistor TR1 may include a first active pattern ACT1 and a first gate electrode GE1, and the second transistor TR2 may include a second active pattern ACT2 and a second gate electrode GE2. The light-emitting element LED may include a pixel electrode PE, a light-emitting layer EML, and a common electrode CE.

The display device DD' described with reference to FIG. 14 may be substantially the same as or similar to the display device DD described with reference to FIGS. 3 and 4, except for the first transistor TR1 and the second transistor TR2. Hereinafter, overlapping descriptions will be omitted or simplified.

The first lower metal layer BML1 and the second lower metal layer BML2 may be disposed on the substrate SUB. For example, the first lower metal layer BML1 and the second lower metal layer BML2 may include metal, alloy, metal nitride, conductive metal oxide, transparent conductive material, and the like. These can be used alone or in combination with each other.

The first lower metal layer BML1 and the second lower metal layer BML2 may transmit a signal and/or voltage to the first transistor TR1 and the second transistor TR2, respectively. For example, in an embodiment, the second lower metal layer BML2 may be electrically connected to the second gate electrode GE2 or a separate power supply line. In an embodiment, the second lower metal layer BML2 may be omitted.

The first voltage line VL1 and the second voltage line VL2 may be disposed on the substrate SUB. The first voltage line VL1 and the second voltage line VL2 may be disposed in the same layer as the first lower metal layer BML1 and the second lower metal layer BML2. That is, the first voltage line VL1 and the second voltage line VL2 may include the same material as the first lower metal layer BML1 and the second lower metal layer BML2 and may be formed through the same process. Various voltages (e.g., the driving voltage ELVDD or the data voltage DATA of FIG. 2) may be applied to the first voltage line VL1 and the second voltage line VL2, respectively.

The first active pattern ACT1 may be disposed on the buffer layer BUF. In an embodiment, the first active pattern ACT1 may include a lower layer LL including an amorphous oxide semiconductor and an upper layer UL including a crystalline oxide semiconductor disposed on the lower layer LL. Accordingly, the driving range of the driving transistor (e.g., the first transistor T1 of FIG. 2) may be widened.

The lower layer LL may have a first channel region CH1, a first conductive region CD1, and a second conductive region CD2. The first channel region CH1 may be positioned between the first conductive region CD1 and the second conductive region CD2. The first and second conductive regions CD1 and CD2 may be regions conductive as n+ type. However, embodiments of the present disclosure are not necessarily limited thereto. The first channel region CH1 may be a non-conductive region.

The upper layer UL may have a second channel region CH2, a third conductive region CD3, and a fourth conductive region CD4. The second channel region CH2 may be located between the third conductive region CD3 and the fourth conductive region CD4. The second channel region CH2 may overlap the first channel region CH1 in the plan view, and the third conductive region CD3 and the fourth conductive region CD4 may at least partially overlap the first conductive region CD1 and the second conductive region CD2 in the plan view, respectively. The third and fourth conductive regions CD3 and CD4 may be regions conductive as n+ type. However, embodiments of the present disclosure are not necessarily limited thereto. The second channel region CH2 may be a non-conductive region.

In an embodiment, the overlap between the first channel region CH1 and the second channel region CH2 may allow both layers of the first active pattern ACT1 to cooperatively contribute to current modulation when a gate voltage is applied. The presence of the second channel region CH2 above the first channel region CH1 may improve electron mobility due to the crystallinity of the upper layer UL, while the amorphous lower layer LL may provide improved threshold voltage stability. This vertically layered channel configuration may thus enable a more robust driving transistor with improved electrical characteristics and reliability under prolonged operation.

In an embodiment, a width of the lower layer LL may be greater than a width of the upper layer UL. Here, the width refers to the length in the first direction DR1.

A first hole H1 and a second hole H2 exposing at least portion of an upper surface of the buffer layer BUF may be defined in the lower layer LL. The first hole H1 may be surrounded by the first conductive region CD1, and the second hole H2 may be surrounded by the second conductive region CD2. That is, the first conductive region CD1 may have a planar shape surrounding the first hole H1, and the second conductive region CD2 may have a planar shape surrounding the second hole H2.

In an embodiment, a step may exist between an end portion of the upper layer UL facing the first connecting electrode CNE1 and to an end portion of the first conductive region CD1 facing the connecting electrode CNE1 and exposed by the first hole H1, and a step may exist between an end portion of the upper layer UL facing the second connecting electrode CNE2 and an end portion of the second conductive region CD2 facing the second connecting electrode CNE2 and exposed by the second hole H2.

A thickness TH1 of the lower layer LL may be more than about 50 angstroms. For example, the thickness TH1 of the lower layer LL may be in a range of more than about 50 angstroms and less than about 300 angstroms. If the thickness TH1 of the lower layer LL is less than or equal to about 50 angstroms, etching of the lower layer LL may not be easy, and there may be difficulty in forming the first active pattern ACT1 and the second active pattern ACT2. If the thickness TH1 of the lower layer LL is more than or equal to about 300 angstroms, process characteristics may deteriorate.

A thickness TH2 of the upper layer UL may be less than about 100 angstroms. For example, the thickness TH2 of the upper layer UL may be in a range of more than about 20 angstroms and less than about 100 angstroms. If the thickness TH2 of the upper layer UL is less than or equal to about 20 angstroms, crystalline growth may not proceed smoothly, and current flow through the upper layer UL may not be smooth. If the thickness TH2 of the upper layer UL is more than about 100 angstroms, process characteristics may deteriorate.

In an embodiment, the selected thicknesses of the lower layer LL and the upper layer UL may also be improved to control the vertical distribution of carriers and the electric field coupling with the gate electrode. A relatively thinner upper layer UL may allow the gate electrode GE1 to effectively modulate both channel regions CH1 and CH2, while still allowing the third and fourth conductive regions CD3 and CD4 to maintain reliable ohmic contact with the connecting electrodes. In contrast, the comparatively thicker lower layer LL may serve as a foundation that supports stable channel formation and suppresses short-channel effects.

The second active pattern ACT2 may be disposed on the buffer layer BUF. The second active pattern ACT2 may include a metal oxide semiconductor. In an embodiment, the second active pattern ACT2 may include an amorphous oxide semiconductor.

In an embodiment, the second active pattern ACT2 may be disposed in the same layer as the lower layer LL of the first active pattern ACT 1. That is, the second active pattern ACT2 may be formed through the same process as the lower layer LL of the first active pattern ACT1 and may include the same material as the lower layer LL of the first active pattern ACT1. A thickness of the second active pattern ACT2 may be the same as the thickness TH1 of the lower layer LL of the first active pattern ACT1.

That is, the first active pattern ACT1 may have a two-layer structure in which an amorphous oxide semiconductor and a crystalline silicon semiconductor are stacked, and the second active pattern ACT2 may have a single-layer structure including an amorphous oxide semiconductor.

In this configuration, in an embodiment, the second active pattern ACT2 provides a simpler, single-layer structure for the second transistor TR2, which may be used in switching or control roles where the enhanced drive strength of the dual-layer configuration is not required. By selectively employing a dual-layer structure for the driving transistor TR1 and a single-layer structure for the secondary transistor TR2, the overall process complexity and material usage can be improved without sacrificing performance in key circuit regions.

The second active pattern ACT2 may include a third channel region CH3, a fifth conductive region CD5, and a sixth conductive region CD6. The third channel region CH3 may be positioned between the fifth conductive region CD5 and the sixth conductive region CD6. For example, the fifth conductive region CD5 and the sixth conductive region CD6 may be regions conductive as an n+ type. However, embodiments of the present disclosure are not necessarily limited thereto. The third channel region CH3 may be a non-conductive region.

A third hole H3 and a fourth hole H4 exposing at least portion of an upper surface of the buffer layer BUF may be defined in the second active pattern ACT2. The third hole H3 may be surrounded by the fifth conductive region CD5, and the fourth hole H4 may be surrounded by the sixth conductive region CD6. That is, the fifth conductive region CD5 may have a planar shape surrounding the third hole H3, and the sixth conductive region CD6 may have a planar shape surrounding the fourth hole H4.

The gate insulating layer GI may be disposed on the buffer layer BUF, the first active pattern ACT1, and the second active pattern ACT2. The gate insulating layer GI may cover at least portion of each of the first active pattern ACT1 and the second active pattern ACT2. A first opening OP1 connected to the first hole H1, a second opening OP2 connected to the second hole H2, a third opening OP3 connected to the third hole H3, and a fourth opening OP4 connected to the fourth hole H4 may be defined in the gate insulating layer GI.

For example, the first opening OP1 may expose the first hole H1, the first conductive region CD1, and the third conductive region CD3, and the second opening OP2 may expose the second hole H2, the second conductive region CD2, and the fourth conductive region CD4. In addition, the third opening OP3 may expose the third hole H3 and the fifth conductive region CD5, and the fourth opening OP4 may expose the fourth hole H4 and the sixth conductive region CD6.

The first gate electrode GE1 and the second gate electrode GE2 may be disposed on the gate insulating layer GI. The first gate electrode GE1 may overlap the first channel region CH1 and the second channel region CH2 in the plan view, and the second gate electrode GE2 may overlap the third channel region CH3 in the plan view.

In an embodiment, the first transistor TR1 may correspond to the first transistor T1 of FIG. 2, and the second transistor TR2 may correspond to the second transistor T2 or the third transistor T3 of FIG. 2.

The first connecting electrode CNE1, the second connecting electrode CNE2, the third connecting electrode CNE3, and the fourth connecting electrode CNE4 may be disposed on the gate insulating layer GI. The first connecting electrode CNE1 may be connected (or in contact) with the first lower metal layer BML1 through a first contact hole CNT1 penetrating the buffer layer BUF and the gate insulating layer GI, the second connecting electrode CNE2 may be connected (or in contact) with the first voltage line VL1 through a second contact hole CNT2 penetrating the buffer layer BUF and the gate insulating layer GI, and the fourth connecting electrode CNE4 may be connected (or in contact) with the second voltage line VL2 through a third contact hole CNT3 penetrating the buffer layer BUF and the gate insulating layer GI.

In addition, the first connecting electrode CNE1 may be connected (or in contact) with the first conductive region CD1 through the first opening OP1, the second connect connecting electrode CNE2 may be connected (or in contact) with the second conductive region CD2 through the second opening OP2, the third connecting electrode CNE3 may be connected (or in contact) with the fifth conductive region CD5 through the third opening OP3, and the fourth connecting electrode CNE4 may be connected (or in contact) with the fifth conductive region CD6 through the fourth opening OP4.

That is, the first connecting electrode CNE1 may extend into the inside of the first opening OP1 and may not extend into the inside of the first hole H1. The second connecting electrode CNE2 may extend into the inside of the second opening OP2 and may not extend into the inside of the second hole H2. The third connecting electrode CNE3 may extend into the inside of the third opening OP3 and may not extend into the inside of the third hole H3. The fourth connecting electrode CNE4 may extend into the inside of the fourth opening OP4 and may not extend into the inside of the fourth hole H4.

Accordingly, the first connecting electrode CNE1 may electrically connect the first lower metal layer BML1 and the first active pattern ACT1, and the second connecting electrode CNE2 may electrically connect the first voltage line VL1 and the first active pattern ACT1. In addition, the third connecting electrode CNE3 may electrically connect the second active pattern ACT2, and the fourth connecting electrode CNE4 may electrically connect the second voltage line VL2 and the second active pattern ACT2.

In an embodiment, the first connecting electrode CNE1, the second connecting electrode CNE2, the third connecting electrode CNE3, and the fourth connecting electrode CNE4 may be disposed in the same layer as the first gate electrode GE1 and the second gate electrode GE2. That is, the first connecting electrode CNE1, the second connecting electrode CNE2, the third connecting electrode CNE3, and the fourth connecting electrode CNE4 may include the same material as the first gate electrode GE1 and the second gate electrode GE2 and may be formed through the same process as the first gate electrode GE1 and the second gate electrode GE2.

The pixel electrode PE may be disposed on the via insulating layer VIA. The pixel electrode PE may be connected to the first connecting electrode CNE1 through a contact hole penetrating the via insulating layer VIA.

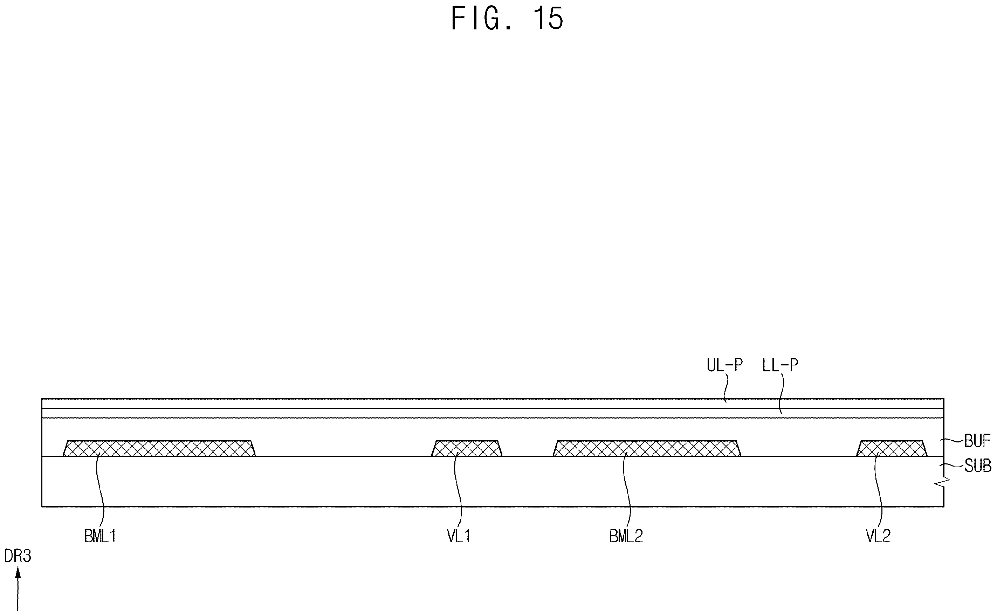

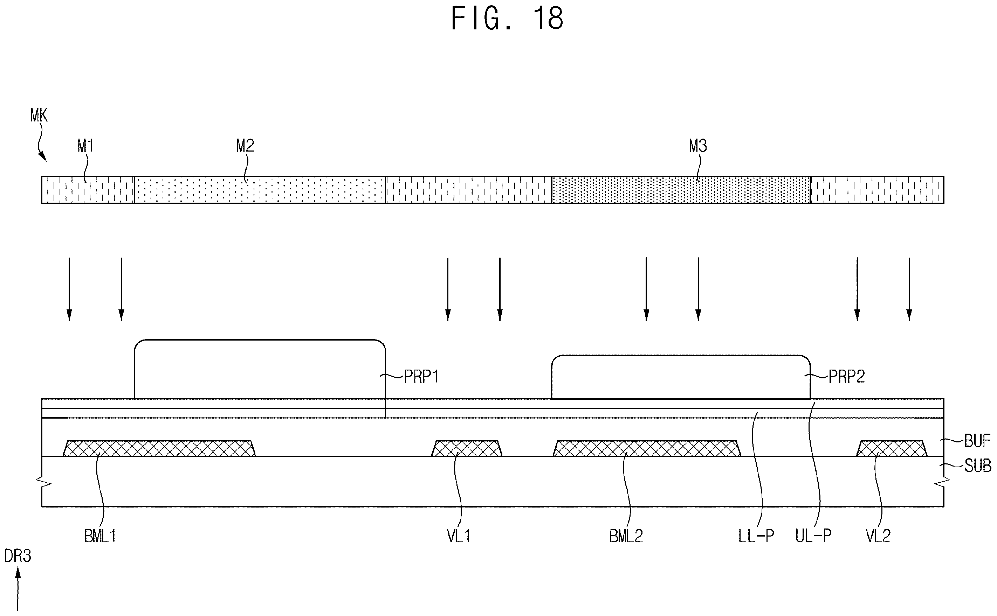

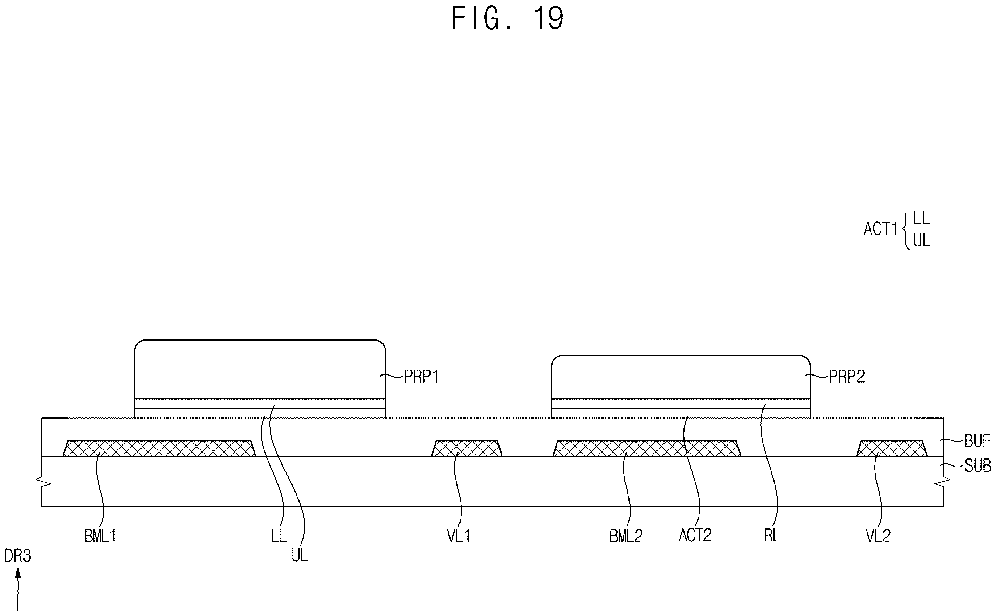

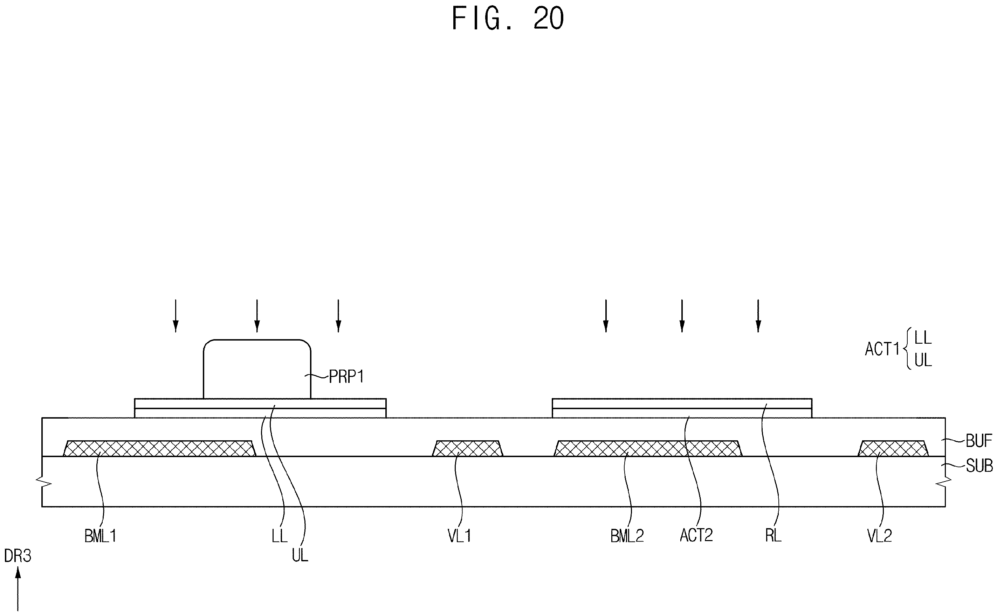

FIGS. 15 to 29 are cross-sectional views illustrating a method of manufacturing the transistor substrate of FIG. 3. Hereinafter, overlapping contents with respect to the transistor substrate TS' described with reference to FIG. 14 will be omitted or simplified.

Referring to FIG. 15, the first and second lower metal layers BML1 and BML2 and the first and second voltage lines VL1 and VL2 may be formed simultaneously through the same process on the substrate SUB.

The buffer layer BUF covering the first and second lower metal layers BML1 and BML2 and the first and second voltage lines VL1 and VL2 may be formed on the substrate SUB. A preliminary lower layer LL-P and a preliminary upper layer UL-P may be sequentially formed on the buffer layer BUF. In an embodiment, each of the preliminary lower layer LL-P and the preliminary upper layer UL-P may be formed using a metal oxide semiconductor.

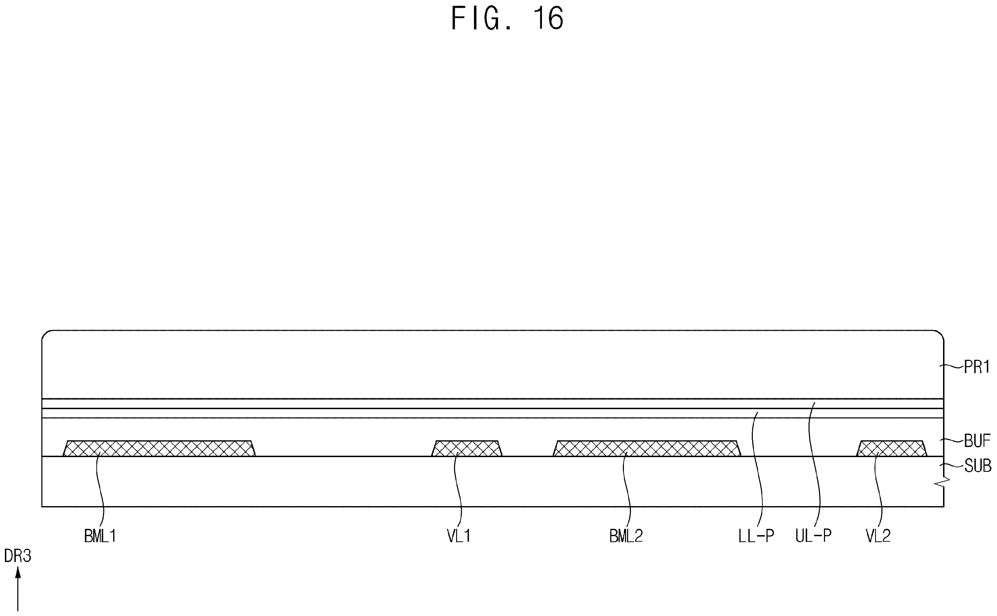

Referring to FIG. 16, in an embodiment, a first photosensitive organic layer PR1 may be entirely formed on the preliminary upper layer UL-P. For example, the first photosensitive organic layer PR1 may include a positive photoresist. In an embodiment, the first photosensitive organic layer PR1 may include a negative photoresist.

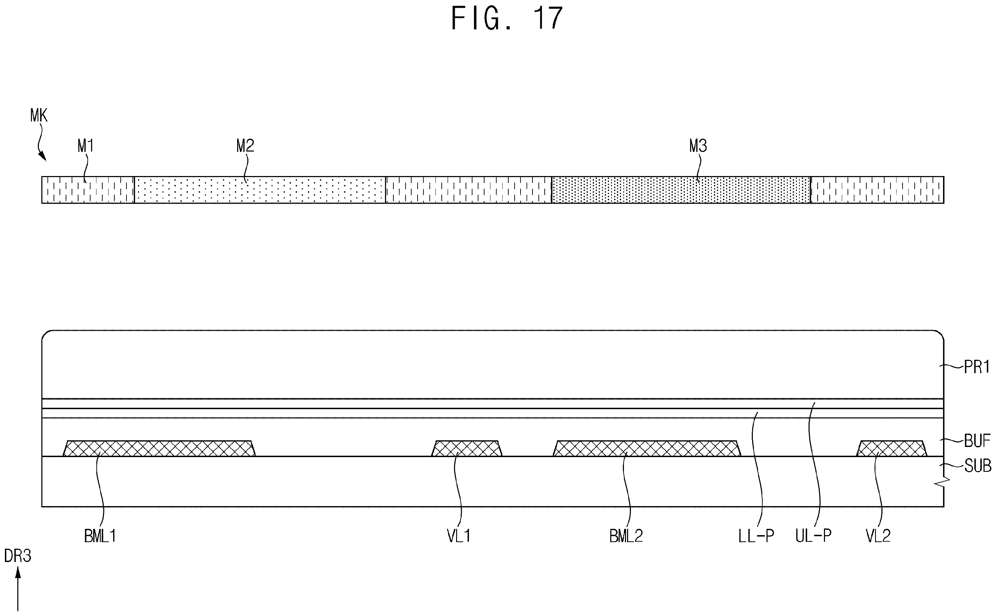

Referring to FIGS. 17, 18, 19, and 20, a mask MK may be disposed on the first photosensitive organic layer PR1. In an embodiment, the mask MK may be a halftone mask. For example, the mask MK may include a transmission portion M1, a light-blocking portion M2, and a semi-transmission portion M3. The transmission portion M1 may fully transmit light, the light-blocking portion M2 may completely block light, and the semi-transmission portion M3 may transmit some of light.

The first photosensitive organic layer PR1 may be exposed and developed through the mask MK, such that the portion of the first photosensitive organic layer PR1 corresponding to the transmission portion M1 may be removed, the portion corresponding to the light-shielding portion M2 may remain to form a first photoresist pattern PRP1, and a portion of the portion corresponding to the semi-transmission portion M3 may be removed to form a second photoresist pattern PRP2. Accordingly, the first photoresist pattern PRP1 and the second photoresist pattern PRP2 may have different thicknesses.

Through a first etching process using the first photoresist pattern PRP1 and the second photoresist pattern PRP2 as masks, a portion of the preliminary lower layer LL-P and a portion of the preliminary upper layer UL-P may be removed. For example, the portion of the preliminary lower layer LL-P and the portion of the preliminary upper layer UL-P which do not overlap the first photoresist pattern PRP1 and the second photoresist pattern PRP2 may be removed through the first etching process. Accordingly, the first active pattern ACT1 including the lower layer LL overlapping the first photoresist pattern PRP1 and the upper layer UL disposed on the lower layer LL may be formed, and simultaneously, the second active pattern ACT2 overlapping the second photoresist pattern PRP2 and a residual layer RL on the second active pattern ACT2 may be formed.

For example, the first etching process may be a wet etching process. However, embodiments of the present disclosure are not necessarily limited thereto.

Through an ashing process, a portion of the first photoresist pattern PRP1 may be removed, and the entirety of second photoresist pattern PRP2 may be removed. For example, the first photoresist pattern PRP 1 may be patterned so as to overlap a portion (e.g., the center portion) of the first active pattern ACT1 in the plan view through the ashing process.

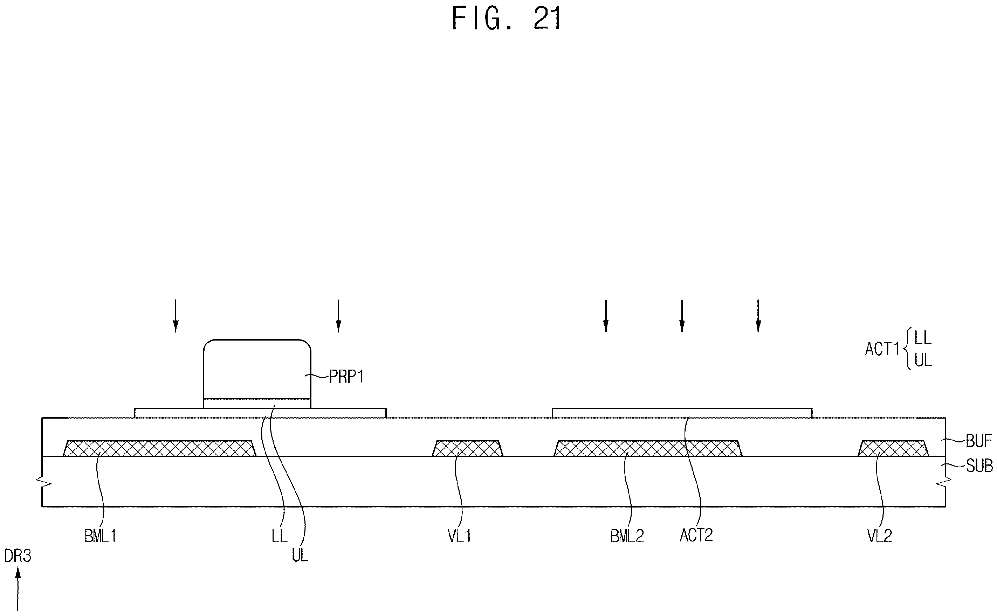

Referring to FIG. 21, through a second etching process using the first photoresist pattern PRP 1 as a mask, a portion of the upper layer UL and the residual layer RL may be removed. For example, the portion of the upper layer UL which do not overlap the first photoresist pattern PRP1 and the entirety of residual layer RL may be removed through the second etching process. Accordingly, the upper surface of the upper layer UL which does not overlap the lower layer LL may be exposed, and the entire upper surface of the second active pattern ACT2 may be exposed.

For example, the second etching process may be a dry etching process. However, embodiments of the present disclosure are not necessarily limited thereto.

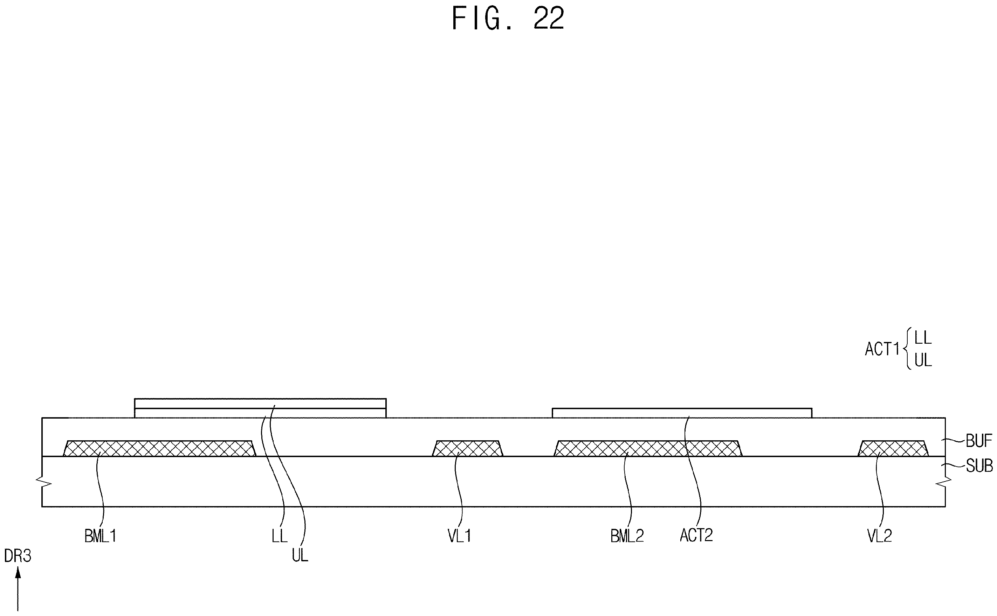

Referring to FIG. 22, the first photoresist pattern PRP1 may be removed. After the first photoresist pattern PRP1 is removed, a heat treatment process may be performed on the upper layer UL. Accordingly, the upper layer UL may have a crystalline structure. That is, the upper layer UL may include a crystalline oxide semiconductor. In contrast, the lower layer LL and the second active pattern ACT2 may include an amorphous oxide semiconductor.

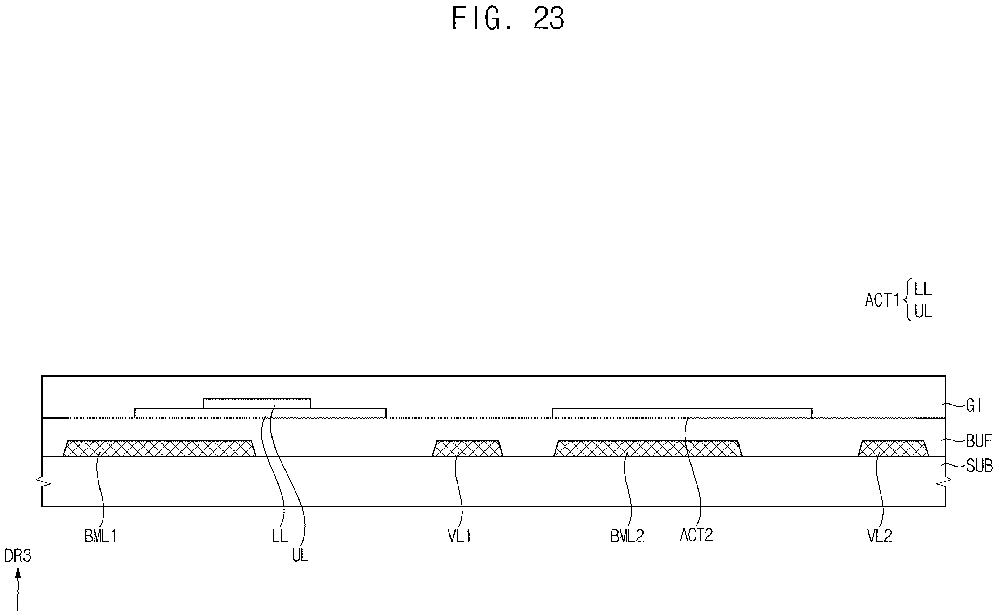

Referring to FIG. 23, the gate insulating layer GI covering the first active pattern ACT 1 and the second active pattern ACT2 may be formed on the buffer layer BUF.

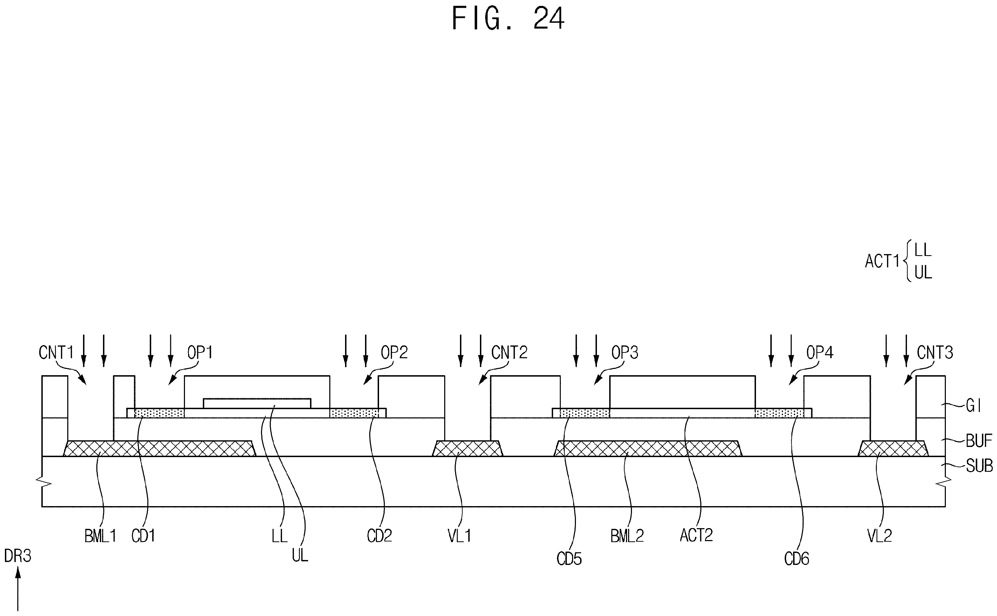

Referring to FIG. 24, through a third etching process, a portion of each of the buffer layer BUF and the gate insulating layer GI may be removed. Accordingly, the first contact hole CNT1 exposing at least portion of the first lower metal layer BML1, the second contact hole CNT2 exposing at least portion of the first voltage line VL1, and the third contact hole CNT3 exposing at least portion of the second voltage line VL2 may be formed in the buffer layer BUF and the gate insulating layer GI. At substantially the same time, the first opening OP1 exposing at least portion of the lower layer LL, the second opening OP2 exposing at least portion of the lower layer LL, the third opening OP3 exposing at least portion of the second active pattern ACT2, and the fourth opening OP4 exposing at least portion of the second active pattern ACT2 may be formed in the gate insulating layer GI.

For example, the third etching process may be a dry etching process. However, embodiments of the present disclosure are not necessarily limited thereto.

During the process of removing the portion of the gate insulating layer GI through the third etching process, hydrogen included in the gate insulating layer GI may flow into the lower layer LL and the second active pattern ACT2. The portion of the lower layer LL into which hydrogen is introduced from the gate insulating layer GI may have a high carrier concentration due to the hydrogen, thereby have conductivity, and thus may become the first conductive region CD1 and the second conductive region CD2. At substantially the same time, the portion of the second active pattern ACT2 into which hydrogen is introduced from the gate insulating layer GI may have a high carrier concentration due to the hydrogen, thereby have conductivity, and thus may become the fifth conductive region CD5 and the sixth conductive region CD6.

The first conductive region CD1 and the second conductive region CD2 may be exposed by the first opening OP1 and the second opening OP2, respectively, and the fifth conductive region CD5 and the sixth conductive region CD6 may be exposed by the third opening OP3 and the fourth opening OP4, respectively.

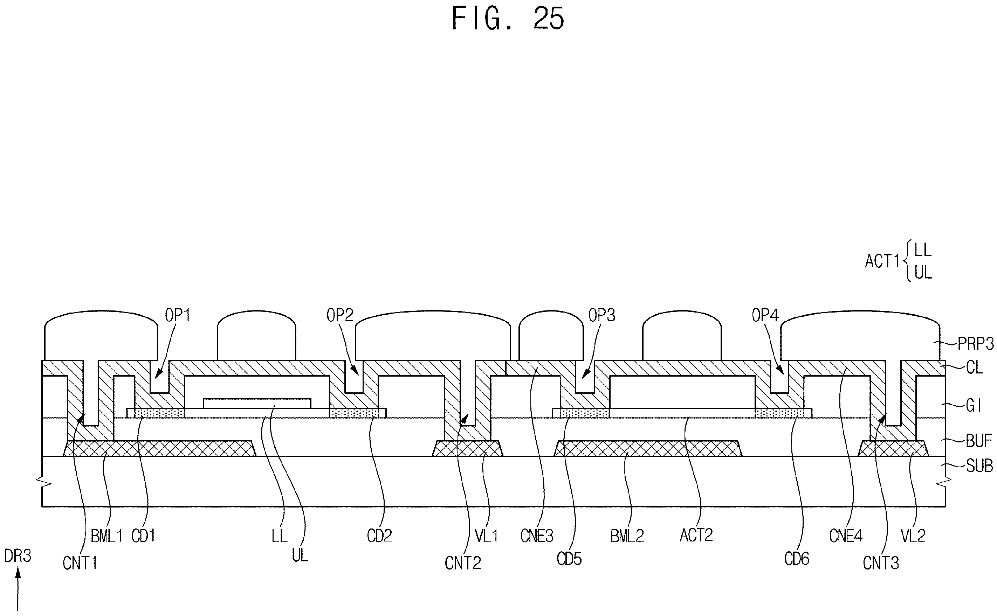

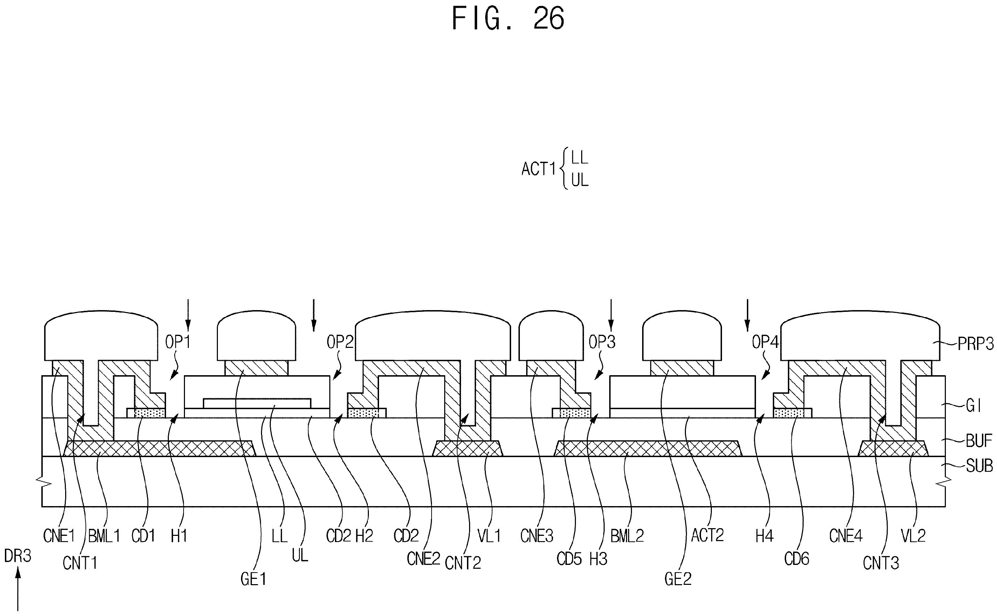

Referring to FIGS. 25 and 26, a conductive layer CL may be formed entirely on the gate insulating layer GI. The conductive layer CL may fill the first, second, and third contact holes CNT1, CNT2, and CNT3, and the first, second, third, and fourth openings OP1, OP2, OP3, and OP4.

A photosensitive organic layer may be formed on the conductive layer CL. A plurality of third photoresist patterns PRP3 may be formed by exposing and developing the photosensitive organic layer. The third photoresist patterns PRP3 may overlap regions where the first connecting electrode CNE1, the first gate electrode GE1, the second connecting electrode CNE2, the third connecting electrode CNE3, the second gate electrode GE2, and the fourth connecting electrode CNE4 are to be formed, respectively.

For example, in an embodiment, the third photoresist patterns PRP3 may include a positive photoresist. In an embodiment, the third photoresist patterns PRP3 may include a negative photoresist.

Through a fourth etching process using the third photoresist patterns PRP3 as masks, a portion of each of the first, second, fifth, and sixth conductive regions CD1, CD2, CD5, and CD6 and a portion of the conductive layer CL may be removed. For example, the portion of each of the first, second, fifth, and sixth conductive regions CD1, CD2, CD5, and CD6 and the portion of the conductive layer CL which do not overlap the third photoresist patterns PRP3 may be removed.

Accordingly, the first connecting electrode CNE1 filling the first contact hole CNT1 and connected to the first conductive region CD1, the first gate electrode GE1 overlapping the center portion of the first active pattern ACT1 in the plan view, the second connecting electrode CNE2 filling the second contact hole CNT2 and connected to the second conductive region CD2, the third connecting electrode CNE3 connected to the fifth conductive region CD5, the second gate electrode GE2 overlapping the center potion of the second active pattern ACT2 in the plan view, and the fourth connecting electrode CNE4 filling the third contact hole CNT3 and connected to the sixth conductive region CD6 may be formed simultaneously. At substantially the same time, a portion of the first conductive region CD1, a portion of the second conductive region CD2, a portion of the fifth conductive region CD5, and a portion of the sixth conductive region CD6 which do not overlap the third photoresist patterns PRP3 may be removed to form the first hole H1, the second hole H2, the third hole H3, and the fourth hole H4, respectively.

For example, the fourth etching process may be a wet etching process. However, embodiments of the present disclosure are not necessarily limited thereto.

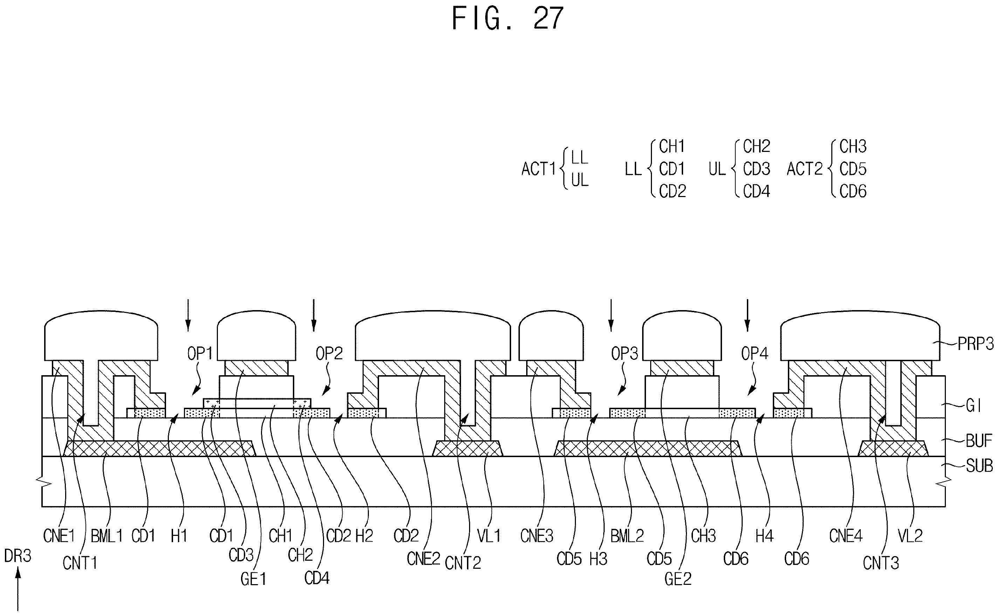

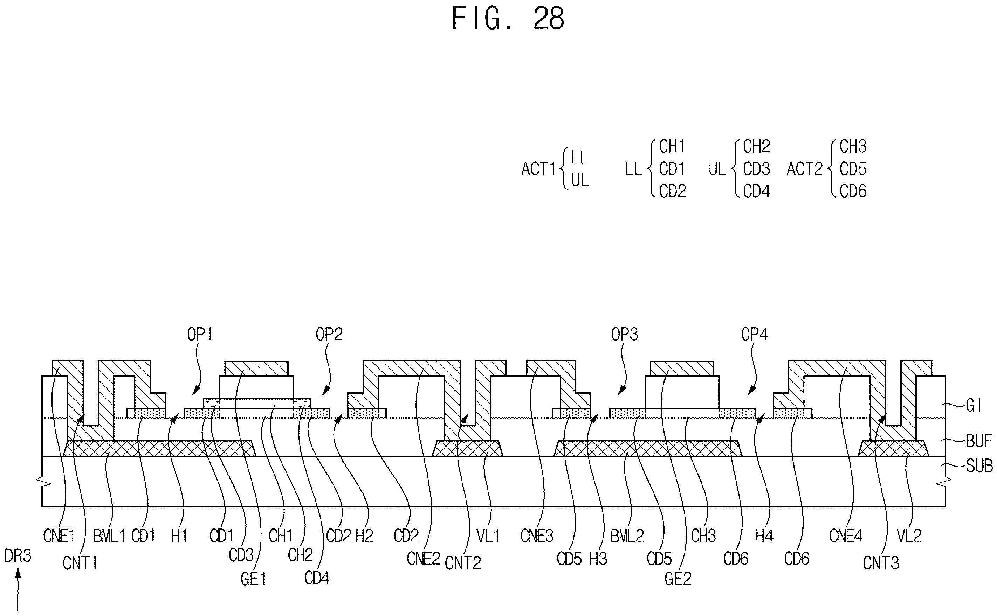

Referring to FIGS. 27 and 28, through a fifth etching process using the third photoresist patterns PRP3 as masks, a portion of the gate insulating layer GI may be removed. For example, a first portion and a second portion of the gate insulating layer GI which do not overlap the third photoresist patterns PRP3 and overlap the first active pattern ACT1 may be removed through the fifth etching process. At substantially the same time, a third portion and a fourth portion of the gate insulating layer GI which do not overlap the third photoresist patterns PRP3 and overlap the second active pattern ACT2 may be removed. Accordingly, the width of each of the first, second, third, and fourth openings OP1, OP2, OP3, and OP4 may be expanded.

For example, the fifth etching process may be a dry etching process. However, embodiments of the present disclosure are not necessarily limited thereto.

During the process of the portion of the gate insulating layer GI through the fifth etching process, hydrogen included in the gate insulating layer GI may flow into the first active pattern ACT1 and the second active pattern ACT2. The portion of the lower layer LL into which hydrogen is introduced from the gate insulating layer GI may have a high carrier concentration due to the introduced hydrogen, thereby have conductivity, and thus may become the first conductive region CD1 and the second conductive region CD2, and the portion of the upper layer UL into which hydrogen is introduced from the gate insulating layer GI may have a high carrier concentration due to the introduced hydrogen, thereby have conductivity, and thus may become the fifth conductive region CD5 and the sixth conductive region CD6. At substantially the same time, the portion of the second active pattern ACT2 into which hydrogen is introduced from the gate insulating layer GI may have conductivity, and thus may become the fifth conductive region CD5 and the sixth conductive region CD6.

That is, after performing the fifth etching process, portions of the lower layer LL overlapping the first portion and second portion of the gate insulating layer GI in the plan view may become the first conductive region CD1 and the second conductive region CD2, respectively, and portions of the upper layer UL overlapping the first portion and second portion of the gate insulating layer GI in the plan view may become the third conductive region CD3 and the fourth conductive region CD4, respectively.

In addition, after performing the fifth etching process, portions of the second active pattern ACT2 overlapping the third portion and fourth portion of the gate insulating layer GI in the plan view may become the fifth conductive region CD5 and the sixth conductive region CD6, respectively.

Accordingly, the first conductive region CD1 may be formed so as to surround the first hole H1, the second conductive region CD2 may be formed so as to surround the second hole H2, the fifth conductive region CD5 may be formed so as to surround the third hole H3, and the sixth conductive region CD6 may be formed so as to surround the fourth hole H4.

In this case, a portion of the lower layer LL into which hydrogen has not been introduced may become the first channel region CH1, a portion of the upper layer UL into which hydrogen has not been introduced may become the second channel region CH2, and a portion of the second active pattern ACT2 into which hydrogen has not been introduced may become the third channel region CH3.

Accordingly, the first transistor TR1 including the first active pattern ACT1 and the first gate electrode GE1, and the second transistor TR2 including the second active pattern ACT2 and the second gate electrode GE2 may be formed. That is, the first gate electrode GE1 may constitute the first transistor TR1 together with the first active pattern ACT1, and the second gate electrode GE2 may constitute the second transistor TR2 together with the second active pattern ACT2.

After the first and second transistors TR1 and TR2 are formed, the third photoresist patterns PRP3 may be removed.

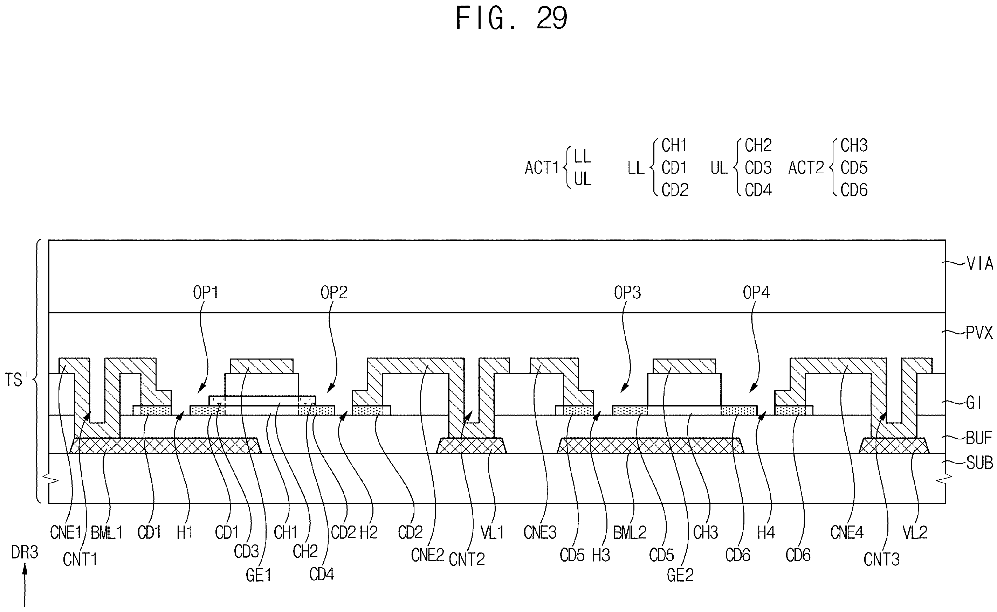

Referring to FIG. 29, the passivation layer PVX and the via insulating layer VIA may be formed on the gate insulating layer GI, the first and second gate electrodes GE1 and GE2, and the first, second, third, and fourth connecting electrodes CNE1, CNE2, CNE3, and CNE4.

Accordingly, the transistor substrate TS' including the first and second voltage lines VL1 and VL2, the first and second lower metal layers BML1 and BML2, the buffer layer BUF, the gate insulating layer GI, the first and second transistors TR1 and TR2, the first, second, third, and fourth connecting electrodes CNE1, CNE2, CNE3, and CNE4, the passivation layer PVX, and the via insulating layer VIA may be manufactured.

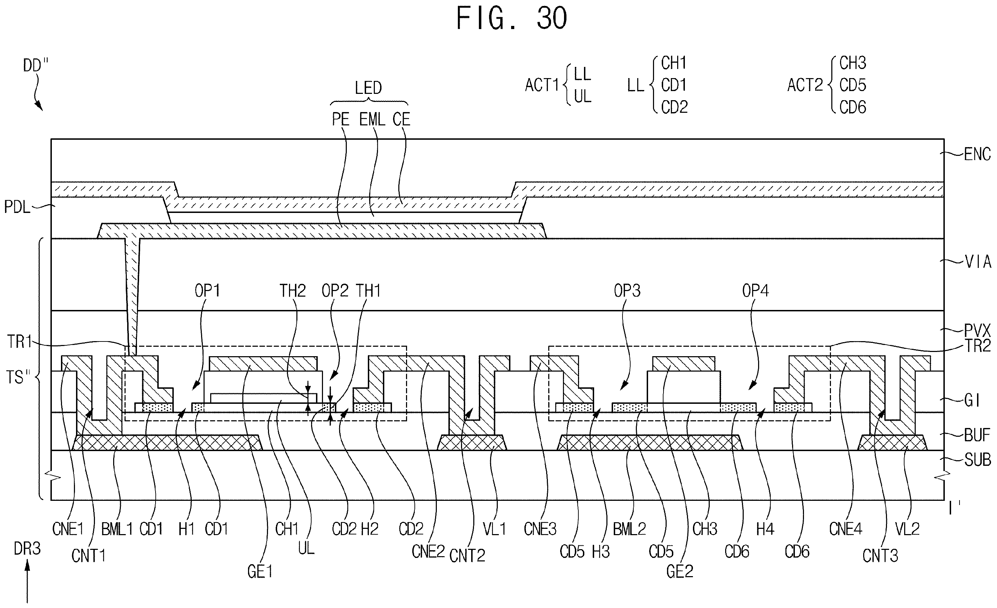

FIG. 30 is a cross-sectional view illustrating an example of a cross-section taken along line I-I' of FIG. 1.

Referring to FIG. 30, a display device DD" according to an embodiment of the present disclosure may include a transistor substrate TS", a pixel defining layer PDL, a light-emitting element LED, and an encapsulation layer ENC sequentially disposed on a substrate SUB.

The transistor substrate TS" may include a first voltage line VL1, a second voltage line VL2, a first lower metal layer BML1, a second lower metal layer BML2, a buffer layer BUF, a gate insulating layer GI, a first transistor TR1, a second transistor TR2, a first connecting electrode CNE1, a second connecting electrode CNE2, a third connecting electrode CNE3, a fourth connecting electrode CNE4, a passivation layer PVX, and a via insulating layer VIA. Here, the first transistor TR1 may include a first active pattern ACT1 and a first gate electrode GE1, and the second transistor TR2 may include a second active pattern ACT2 and a second gate electrode GE2. The light-emitting element LED may include a pixel electrode PE, a light-emitting layer EML, and a common electrode CE.

The display device DD" described with reference to FIG. 30 may be substantially the same as or similar to the display device DD' described with reference to FIG. 14 except for the first transistor TR1 and the gate insulating layer GI. Hereinafter, overlapping descriptions will be omitted or simplified.

The first active pattern ACT1 may be disposed on the buffer layer BUF. In an embodiment, the first active pattern ACT1 may include a lower layer LL including an amorphous oxide semiconductor, and an upper layer UL disposed on the lower layer LL and including a crystalline oxide semiconductor.

The lower layer LL may include a first channel region CH1, a first conductive region CD1, and a second conductive region CD2. The first channel region CH1 may be positioned between the first conductive region CD1 and the second conductive region CD2. For example, the first and second conductive regions CD1 and CD2 may be regions conductive as n+ type. However, embodiments of the present disclosure are not necessarily limited thereto. The first channel region CH1 may be a non-conductive region.

The upper layer UL may not be entirely conductive. The upper layer UL may overlap at least partially the first channel region CH1 in the plan view, and may not overlap the first conductive region CD1 and the second conductive region CD2.

In an embodiment, the width of the lower layer LL may be greater than the width of the upper layer UL. A first hole H1 and a second hole H2 exposing at least a portion of an upper surface of the buffer layer BUF may be defined in the lower layer LL.

The gate insulating layer GI may be disposed on the buffer layer BUF, the first active pattern ACT1, and the second active pattern ACT2. The gate insulating layer GI may cover at least a portion of each of the first active pattern ACT1 and the second active pattern ACT2. In an embodiment, the gate insulating layer GI may entirely cover the upper layer UL. That is, the gate insulating layer GI may entirely cover the side surfaces of the upper layer UL.

The first gate electrode GE1 may be disposed on the gate insulating layer GI. In an embodiment, the first gate electrode GE1 may overlap an entirety of the upper layer UL in the plan view. That is, the entirety of upper layer UL may be covered by the first gate electrode GE1.

In the display devices DD, DD', and DD" according to embodiments of the present disclosure, the transistor TR of the transistor substrate TS disposed in the display area DA may include the active pattern ACT including the lower layer LL including an amorphous oxide semiconductor and the upper layer UL including a crystalline oxide semiconductor. In this case, in an embodiment, both the driving transistor and the switching transistor of the transistor substrate TS may have the same structure as the structure of the transistor TR. In an embodiment, the first transistor TR1 of transistor substrates TS' and TS" disposed in the display area DA may include the first active pattern ACT1 including the lower layer LL including an amorphous oxide semiconductor and the upper layer UL including a crystalline oxide semiconductor, and the second transistor TR2 may include the second active pattern ACT2 having a single-layer structure including an amorphous oxide semiconductor. In this case, the driving transistor of the transistor substrates TS' and TS" may have the same structure as the structure of the first transistor TR1, and the switching transistor may have the same structure as the structure of the second transistor TR2. Accordingly, the driving range of the driving transistor may be widened.

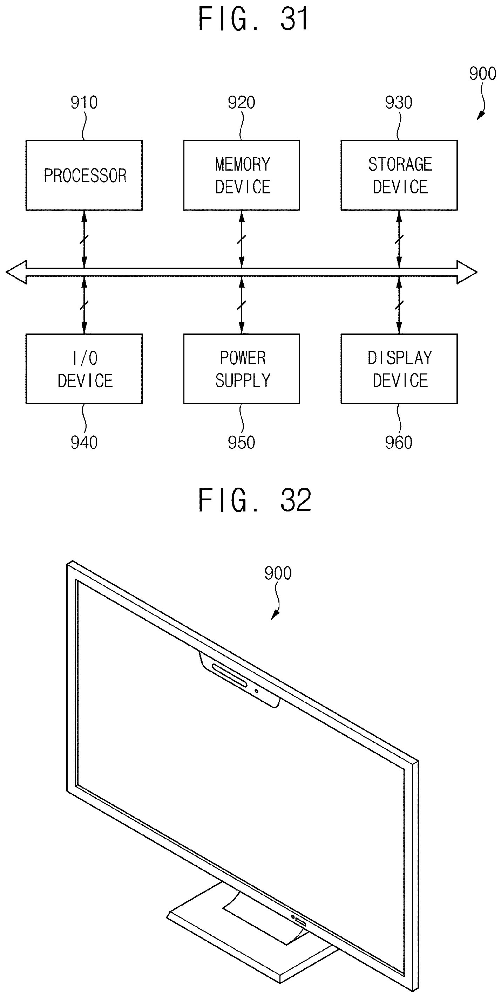

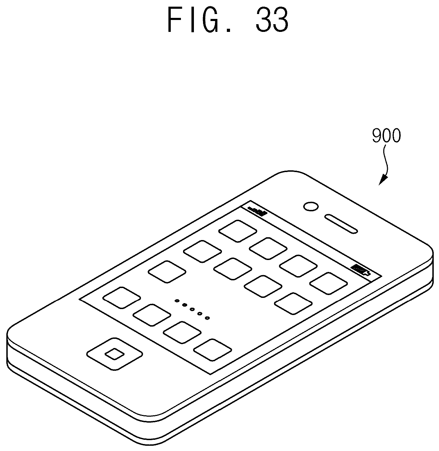

FIG. 31 is a block diagram illustrating an electronic device including the display device of FIG. 1. FIG. 32 is a view illustrating an example of the electronic device of FIG. 31 being implemented as a television. FIG. 33 is a view illustrating an example of the electronic device of FIG. 31 being implemented as a smartphone.

Referring to FIGS. 31, 32, and 33, in an embodiment, an electronic device 900 may include a processor 910, a memory device 920, a storage device 930, an input/output device 940, a power supply 950, and a display device 960. In this case, the display device 960 may correspond to the display device DD described with reference to FIGS. 1 to 4, the display device DD' described with reference to FIG. 14, or the display device DD" described with reference to FIG. 30. The electronic device 900 may further include several ports capable of communicating with a video card, a sound card, a memory card, a USB device, and the like.

In an embodiment, as shown in FIG. 32, the electronic device 900 may be implemented as a television. In an embodiment, as shown in FIG. 33, the electronic device 900 may be implemented as a smartphone. However, the electronic device 900 is not limited thereto, and for example, the electronic device 900 may be implemented as a mobile phone, a video phone, a smart pad, a smart watch, a tablet computer, a vehicle navigation device, a computer monitor, a laptop computer, a head mounted display (HMD), and the like.

The processor 910 may perform certain calculations or tasks. The processor 910 may control the display device 960. In an embodiment, the processor 910 may be, for example, a microprocessor, a central processing unit (CPU), an application processor (AP), and/or the like. The processor 910 may be connected to other components through, for example, an address bus, a control bus, a data bus, and the like. The processor 910 may also be connected to an expansion bus, such as a peripheral component interconnect (PCI) bus.

The memory device 920 may store data necessary for the operation of the electronic device 900. For example, the memory device 920 may include an erasable programmable read-only memory (EPROM) device, an electrically erasable programmable read-only memory (EEPROM) device, a flash memory device, a phase change random access memory (PRAM) device, a resistance random access memory (RRAM) device, a nano floating GEe memory (NFGM) device, a polymer random access memory (PoRAM) device, a magnetic random access memory (MRAM) device, a non-volatile memory device such as a ferroelectric random access memory (FRAM) device and/or a volatile memory device such as a dynamic random access memory (DRAM) device, a static random access memory (SRAM) device, and a mobile DRAM device, and the like.

The storage device 930 may include, for example, a solid state drive (SSD), a hard disk drive (HDD), a CD-ROM, and the like.

The input/output device 940 may include input means such as, for example, a keyboard, keypad, touch pad, touch screen, mouse, and the like and output means such as, for example, a speaker, a printer, and the like.

The power supply 950 may supply power necessary for the operation of the electronic device 900 to the display device 960. The display device 960 may be connected to other components through buses or other communication links. In an embodiment, the display device 960 may be included in the input/output device 940.

Embodiments of the present disclosure may be applied to various display device which can be equipped with a display device. For example, embodiments of the present disclosure may be applied to high-resolution smartphones, mobile phones, smart pads, smart watches, tablet computers, vehicle navigation systems, televisions, computer monitors, and notebook computers.

While the present disclosure has been particularly shown and described with reference to embodiments thereof, it will be understood by those of ordinary skill in the art that various changes in form and detail may be made therein without departing from the scope of the present disclosure as defined by the following claims.

## Claims

1. A transistor substrate, comprising:
a substrate (SUB);
a first active pattern (ACT1) disposed on the substrate and including:
a lower layer (LL) including an amorphous oxide semiconductor and having a first conductive region (CD1), a second conductive region (CD2), and a first channel region (CH1) positioned between the first and second conductive regions (CD1, CD2); and
an upper layer (UL) disposed on the lower layer and including a crystalline oxide semiconductor;
a first gate electrode (GE1) disposed on the first active pattern and overlapping the first channel region in a plan view,
a first connecting electrode (CNE1) contacting the first conductive region; and
a second connecting electrode (CNE2) contacting the second conductive region,
wherein the first gate electrode (GE1) and the first active pattern (ACT1) form a first transistor.

2. The transistor substrate of claim 1, wherein a first-first hole (H11) surrounded by the first conductive region (CD1) and a second-first hole surrounded by the second conductive region (CD2) are defined in the lower layer,
a first-second hole (H12) exposing the first-first hole and a second-second hole exposing the second-first hole are defined in the upper layer, and
a width of the first-first hole is smaller than a width of the first-second hole, and a width of the second-first hole is smaller than a width of the second-second hole.

3. The transistor substrate of claim 1 or 2, wherein the first connecting electrode (CNE1) contacts the first conductive region (CD1) through the first-second hole and does not overlap the first-first hole in the plan view, and
the second connecting electrode contacts the second conductive region (CD2) through the second-second hole and does not overlap the second-first hole in the plan view., and/or
wherein the first connecting electrode (CNE1) faces the second connecting electrode (CNE2) in one direction, and
a length of the lower layer in the one direction is about equal to a length of the upper layer in the one direction.

4. The transistor substrate of any of the preceding claims, wherein the upper layer (UL) includes a third conductive region (CD3) at least partially overlapping the first conductive region (CD1) in the plan view, a fourth conductive region (CD4) at least partially overlapping the second conductive region (CD2) in the plan view, and a second channel region (CH2) overlapping the first channel region in the plan view.

5. The transistor substrate of claim 4, further comprising:
a gate insulating layer (GI) disposed between the first active pattern (ACT1) and the first gate electrode (GE1),
wherein a first opening (OP1) exposing the third conductive region (CD3), the first-first hole (H11), and the first-second hole (H12), and a second opening (OP2) exposing the fourth conductive region (CD3), the second-first hole (H21), and the second-second hole (H22) are defined in the gate insulating layer.

6. The transistor substrate of any of the preceding claims, wherein a thickness of the upper layer (UL) is in a range of less than about 100 angstroms, Å, and a thickness of the lower layer is in a range of more than about 50 angstroms, Å, and less than about 300 angstroms, Å.

7. The transistor substrate of any of the preceding claims, further comprising:
a second active pattern (ACT2) disposed on the substrate, including an amorphous oxide semiconductor, and having a conductive region (CD5, CD6) and a channel region (CH3); and
a second gate electrode (GE2) disposed on the second active pattern and overlapping the channel region (CH3) in the plan view,
wherein the second gate electrode (ACT2) and the second active pattern (GE2) form a second transistor,
wherein the conductive region includes a fifth conductive region (CD5) and a sixth conductive region (CD6), and
the third channel region (CH3) is positioned between the fifth conductive region (CD5) and the sixth conductive region (CD6), and/or
wherein a third hole (H3) surrounded by the fifth conductive region (CD5) and a fourth hole (H4) surrounded by the sixth conductive region (CD6) are defined in the second active pattern (ACT2).

8. The transistor substrate of claim 7, wherein the upper layer has a third conductive region at least partially overlapping the first conductive region in the plan view, a fourth conductive region at least partially overlapping the second conductive region in the plan view, and a second channel region overlapping the first channel region in the plan view, and
a first hole (H1) surrounded by the first conductive region (CD1) and a second hole (H2) surrounded by the second conductive region (CD2) are defined in the lower layer.

9. The transistor substrate of claim 8, wherein a first step is disposed exists between an end portion of the upper layer (UL) facing the first connecting electrode (CNE1) and an end portion of the first conducting region (CD1) exposed by the first hole and facing the first connecting electrode, and
a second step is disposed exists between an end portion of the upper layer (UL) facing the second connecting electrode (CNE2) and an end portion of the second conducting region (CD2) exposed by the second hole and facing the second connecting electrode.

10. An electronic device, comprising:
a display device (960);
a power supply (950) which supplies power to the display device; and
a processor (910) which controls the display device,
wherein the display device includes a transistor substrate of any of the preceding claims.

11. A method of manufacturing a transistor substrate of any of the preceding claims, the method comprising:
forming a first active pattern (ACT1) including a lower layer (LL) including an amorphous oxide semiconductor and having a first conductive region (CD1), a second conductive region (CD2), and a first channel region (CH1) positioned between the first and second conductive regions;
forming an upper layer (UL) on the lower layer, wherein the upper layer includes a crystalline oxide semiconductor;
forming a first gate electrode (GE1) on the first active pattern (ACT1),
wherein the first gate electrode (GE1) overlaps the first channel region (CH1) in a plan view, and the first gate electrode (GE1) and the first active pattern (ACT1) form a first transistor; and
forming a first connecting electrode contacting the first conductive region (CD1) and a second connecting electrode contacting the second conductive region.

12. The method of claim 11, wherein forming the first active pattern (ACT1) includes:
forming the lower layer (LL) and the upper layer (UL) on the substrate;
performing a heat treatment process on the upper layer;
forming a gate insulating layer covering the lower layer and the upper layer;
removing a portion of the gate insulating layer to form a first-second hole and a second-second hole exposing at least a portion of the lower layer (LL) to the upper layer (UL);
forming a conductive layer filling the first-second hole and the second-second hole on the gate insulating layer; and
forming photoresist patterns on the conductive layer,
wherein a portion exposed by the first-second hole of the lower layer (LL) becomes the first conductive region (CD1) and a portion exposed by the second-second hole of the lower layer (LL) becomes the second conductive region (CD2) when forming the first-second hole and the second-second hole.

13. The method of claim 12, wherein after forming the conductive layer, the method further comprises:
removing a portion of each of the conductive layer, the first conductive region, and the second conductive region (CD2) using the photoresist patterns as a mask to form a first-first hole exposed by the first-second hole and a second-first hole exposed by the second-second hole in the lower layer (LL);
removing a first portion and a second portion of the gate insulating layer overlapping the first active pattern (ACT1) using the photoresist patterns as a mask; and
removing the photoresist patterns,
wherein portions of the lower layer overlapping the first portion and the second portion in the plan view become the first conductive region (CD1) and the second conductive region, respectively, and portions of the upper layer overlapping the first portion and the second portion in the plan view become a third conductive region (CD3) and a fourth conductive region (CD4), respectively, when removing the first portion and the second portion.

14. The method of claim 11, further comprising:
forming a second active pattern (ACT2) on the substrate, the second active pattern (ACT1) including an amorphous oxide semiconductor and having a conductive region (CD5, CD6) and a channel region; and
forming a second gate electrode (GE2) on the second active pattern and overlapping the channel region (CH3) in the plan view,
wherein the second gate electrode and the second active pattern form a second transistor

15. The method of claim 14, wherein forming the second active pattern (ACT2) includes:
forming a preliminary lower layer on the substrate;
forming a preliminary upper layer on the preliminary lower layer;
removing a portion of the preliminary lower layer to form the lower layer and the second active pattern, and simultaneously removing a portion of the preliminary upper layer to form the upper layer and a residual layer on the second active pattern;
removing a portion of the upper layer and an entirety of the residual layer;
performing a heat treatment process on the upper layer;
forming a gate insulating layer covering the lower layer, the upper layer, and the second active pattern;
removing a portion of the gate insulating layer to expose a portion of the lower layer and a portion of the second active pattern;
forming a conductive layer on the gate insulating layer; and
forming a third photoresist pattern on the conductive layer,
wherein an exposed portion of the lower layer (LL) becomes the first conductive region (CD1) and the second conductive region (CD2) and an exposed portion of the second active pattern (ACT2) becomes the conductive region when exposing the portion of the lower layer (LL) and the portion of the second active pattern.

16. The method of claim 15, wherein forming the lower layer (LL), the second active layer (ACT2), the upper layer (UL), and the residual layer includes:
forming a photosensitive organic layer on the preliminary upper layer;
exposing and developing the photosensitive organic layer through a halftone mask to form a first photoresist pattern and a second photoresist pattern having different thicknesses;
removing a portion of each of the preliminary lower layer using the first photoresist pattern and the second photoresist pattern as masks to form the lower layer, the second active pattern, the upper layer, and the residual layer; and
removing a portion of the first photoresist pattern and an entirety of the second photoresist pattern through an ashing process,
wherein removing the portion of the upper layer (UL) and the entirety of the residual layer includes:
removing the portion of the upper layer (UL) and the entirety of the residual layer using the first photoresist pattern as a mask; and
removing the first photoresist pattern,
wherein the first photoresist pattern is formed in an area overlapping the lower layer and the upper layer, and the second photoresist pattern is formed in an area overlapping the second active pattern and the residual layer.

17. The method of claim 15, wherein, after forming the conductive layer, the method further comprises:
removing a portion of each of the conductive layer, the first conductive region, and the second conductive region (CD2) using the third photoresist pattern as a mask to form a first hole and a second hole in the lower layer and a third hole in the second active pattern;
removing a first portion and a second portion of the gate insulating layer overlapping the first active pattern in the plan view and a portion of the gate insulating layer overlapping the second active pattern in the plan view using the third photoresist pattern as a mask; and
removing the third photoresist pattern,
wherein the first hole is formed by removing a portion of the first conductive region, the second hole is formed by removing a portion of the second conductive region, and the third hole is formed by removing a portion of the conductive region in the forming the first hole, the second hole, and the third hole.

18. The method of claim 17, wherein in removing the first portion and the second portion,
portions of the lower layer (LL) overlapping the first portion and the second portion in the plan view become the first conductive region (CD1) and the second conductive region (CD2), respectively, and a portion of the second active pattern (ACT2) overlapping the portion of the gate insulating layer becomes the conductive region.
